(19) Europäisches Patentamt
European Patent Office
Office européen des brevets

(11) EP 1 843 387 A1

(12) **EUROPEAN PATENT APPLICATION**
published in accordance with Art. 158(3) EPC

(43) Date of publication:
**10.10.2007 Bulletin 2007/41**

(21) Application number: **06712065.9**

(22) Date of filing: **20.01.2006**

(51) Int Cl.:
***H01L 21/027*** (2006.01) ***G03F 7/038*** (2006.01)
***G03F 7/20*** (2006.01)

(86) International application number:
**PCT/JP2006/300840**

(87) International publication number:
**WO 2006/080250 (03.08.2006 Gazette 2006/31)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.01.2005 JP 2005016578**
**09.09.2005 JP 2005261700**
**07.11.2005 JP 2005322514**

(71) Applicant: **JSR Corporation**
**Tokyo 104-8410 (JP)**

(72) Inventors:
- **FURUKAWA, Taiichi,**
**c/o JSR CORPORATION**
**Tokyo, 1048410 (JP)**
- **HIEDA, Katsuhiko,**
**c/o JSR CORPORATION**
**Tokyo 1048410 (JP)**
- **MIYAMATSU, Takashi,**
**c/o JSR CORPORATION**
**Tokyo 1048410 (JP)**
- **WANG, Yong,**
**c/o JSR CORPORATION**
**Tokyo, 1048410 (JP)**
- **YAMADA, Kinji,**
**c/o JSR CORPORATION**
**Tokyo, 1048410 (JP)**

(74) Representative: **TBK-Patent**
**Bavariaring 4-6**
**80336 München (DE)**

(54) **IMMERSION EXPOSURE SYSTEM, AND RECYCLE METHOD AND SUPPLY METHOD OF LIQUID FOR IMMERSION EXPOSURE**

(57) An immersion exposure system 1 performs an exposure process through a liquid 301 provided between an optical element of a projection optical means 121 and a substrate 111. The immersion exposure system 1 includes a liquid supply section 80 which supplies the liquid 301, an exposure section to which the liquid 301 (301b) supplied from the liquid supply section 80 is continuously introduced along a specific direction and which performs an exposure process in a state in which a space between the optical element of the projection optical means 121 and the substrate 111 is filled with the liquid 301, a liquid recovery section 90 which recovers the liquid 301 (301a) passed through the exposure section 110 at a symmetrical position against the substrate 111, and a liquid recycling section 20 which recycles the liquid 301(301c) recovered by the liquid recovery section 90. The properties of the immersion exposure liquid can be stabilized when applying an immersion method, whereby exposure can be advantageously and continuously performed, and running cost can be reduced.

FIG. 1
1
20
21
22
23
24
25
26
27
REPLENISHMENT LIQUID
N2
N2
28
301d
32a
32b
301c
29
90
80
31
N2
32a
32b
11
12
138
139
211
100
201
101
102
133
121
122
123
301a
134
111
301b
113
114
115
112
301
116
A

EP 1 843 387 A1

## Description

TECEMCAL FIELD

The present invention relates to an immersion exposure tool or an immersion exposure method which performs an exposure process through a liquid provided between an optical element of a projection optical means and a substrate. More particularly, the present invention relates to an immersion exposure system including a means for recycling a liquid, a method of recycling an immersion exposure liquid including a step of recycling the liquid, and a method of supplying an immersion exposure liquid.

BACKGROUND ART

When manufacturing electronic devices such as semiconductor devices and imaging devices, a (projection) exposure device is used which transfers an image of the pattern of a master (reticle or mask) onto each shot region of a substrate (e.g. wafer or glass plate), to which a resist (photosensitive material) is applied, through a projection optical means.

In such an exposure device, the resolution of the projection optical means must be increased in order to deal with miniaturization of circuits of electronic devices accompanying a reduction in size and an increase in the degree of integration of electronic devices. The resolution of the projection optical means increases as the exposure wavelength becomes shorter or the numerical aperture of the projection optical means becomes larger. Therefore, the exposure wavelength used in the exposure device has been reduced and the numerical aperture of the projection optical means has been increased along with miniaturization of circuits. With regard to the exposure wavelength, light with a wavelength of 248 nm (KrF laser light) has been mainly used. In recent years, light with a shorter wavelength (ArF laser light: 193 nm) has been put to practical use. The depth of focus is also important for exposure in addition to the resolution. The resolution R and the depth of focus δ are respectively shown by the following expressions.

$$R = k1 \cdot \lambda / NA \qquad \text{(i)}$$

$$\delta = k2 \cdot \lambda / NA^2 \qquad \text{(ii)}$$

In the expressions (i) and (ii), λ is the wavelength of an exposure laser source under vacuum, NA is the numerical aperture of a projection optical means, and k1 and k2 are process coefficients. When the refractive index of the space between a lens of a projection optical means and a substrate is n, and the maximum incident angle of (exposure) light on the surface of a resist (applied to the substrate) is θ, the numerical aperture NA is shown by the following expression.

$$NA = n\sin\theta \qquad \text{(iii)}$$

As is clear from the expressions (i) and (ii), when reducing the exposure wavelength λ and increasing the numerical aperture NA in order to improve the resolution R, the depth of focus δ decreases. Therefore, when further decreasing the exposure wavelength in order to deal with a further increase in degree of integration of circuits of electronic devices such as semiconductor devices, a margin during exposure may become insufficient due to a narrow depth of focus.

As a method of increasing the depth of focus while substantially decreasing the exposure wavelength, an exposure method called immersion exposure has been proposed (also called "immersion method"; see JP-A-11-176727, for example). In this method, the space between the bottom surface of a projection optical means and the surface of a substrate is filled with a liquid, and the resolution is increased and the depth of focus is enlarged by about n times, utilizing the phenomenon in which the wavelength of the exposure light source in the liquid is 1/n times the wavelength in the air (n is the refractive index of the liquid). According to the immersion method, the resolution R and the depth of focus δ are respectively shown by the following expressions.

$$R = k1 \cdot (\lambda/n)/NA \qquad \text{(iv)}$$

$$\delta = k2 \cdot n\lambda/NA^2 \qquad \text{(v)}$$

For example, when using ArF laser light (193 nm) as the exposure light source in the immersion method, use of water (pure water) as the liquid (hereinafter may be called "immersion exposure liquid") has been studied (see WO99/49504). Since pure water has a refractive index n at a wavelength of 193 nm (corresponding to ArF laser light) of 1.44, pure water is an excellent immersion exposure liquid. According to the immersion method using pure water, the resolution R and the depth of focus δ can be respectively increased by 69.4% and 144% according to the above expressions (iv) and (v) as compared with an exposure method using air as the medium. In the next-generation immersion exposure method in which a further miniaturization of circuits is demanded, an immersion exposure liquid other than pure water having a higher refractive index is required.

The applicant of the present invention has found that an alicyclic hydrocarbon compound such as decalin serves as an immersion exposure liquid suitable for the next-generation immersion exposure method (see Japanese Patent Application No. 2004-151711 and Japanese Patent Application No. 2004-252289 applied for by the applicant of the present invention).

The above alicyclic hydrocarbon compound has a refractive index n for ArF laser light (wavelength: 193 nm) of about 1.6, which is suitable for the immersion exposure liquid. However, since the above compound has high gas solubility in comparison with water, the gases such as oxygen are easily dissolved in the compound. This causes issues when using the compound as the immersion exposure liquid. If oxygen is dissolved in the liquid, the dissolved oxygen absorbs light (exposure light such as ArF laser light or KrF laser light), whereby the energy of light reaching a resist (film) decreases. As a result, the dose of light necessary for resolving the pattern with optimal dimensions decreases, whereby the throughput in terms of wafers processed per unit time may be decreased to a large extent, or the energy of light changes in substrate units depending on the dissolved oxygen content of the liquid, thereby making adjustment difficult. Moreover, the energy in the liquid caused by absorption of light is converted to heat and increases the temperature, whereby a local change in the refractive index of the liquid occurs. This causes a local difference in focus, whereby the pattern of a master (mask) may not be accurately transferred onto the entire surface of the substrate. As a result, the yield of electronic devices decreases, whereby production efficiency may be decreased. Since oxygen is rarely dissolved in pure water to a concentration of parts per million, effects on the absorbance or the transmittance of light (exposure light) are relatively small. Therefore, dissolution of oxygen in pure water does not pose a problem in comparison with the alicyclic hydrocarbon compound.

When using the above alicyclic hydrocarbon compound as the immersion exposure liquid, if impurities other than gas exist in the immersion exposure liquid, the absorbance (or transmittance) of light with a wavelength of 193 nm or 248 nm (corresponding to KrF laser light) tends to be increased. Moreover, the yield of electronic devices may decrease due to insufficient exposure, whereby production efficiency may be decreased.

The issues caused by dissolution of oxygen and contamination with impurities other than gas may be prevented by discarding the immersion exposure liquid after continuous use. However, when using the above alicyclic hydrocarbon compound as the immersion exposure liquid, since the alicyclic hydrocarbon compound is more expensive than pure water, running cost is increased due to an increase in liquid consumption, whereby the total manufacturing cost of electronic devices is increased. This weakens competitiveness. Moreover, when using the above alicyclic hydrocarbon compound (organic compound) as the immersion exposure liquid, it is not desirable to discard the immersion exposure liquid in the viewpoint of environmental protection.

DISCLOSURE OF THE INVENTION

The present invention has been achieved in view of the above issues in the related art. An object of the present invention is to provide an exposure means and a method of supplying a liquid for immersion exposure capable of stabilizing the properties of the liquid when applying an immersion method to achieve advantageous and continuous exposure and reducing running cost. The inventors of the present invention have conducted extensive studies and found that the above object can be achieved by the following means.

According to the present invention, there is provided an immersion exposure system which performs an exposure process through a liquid provided between an optical element of projection optical means and a substrate, the immersion exposure system comprising: a liquid supply section which supplies the liquid; an exposure section which performs an exposure process in a state in which a space between the optical element of the projection optical means and the substrate is filled with the liquid supplied from the liquid supply section; and a liquid recycling section which recovers and recycles the liquid come out of the exposure section; the liquid recycled in the liquid recycling section being returned to the liquid supply section and reused.

In the present invention, it is also preferable to install a liquid recovering section for recovering the liquid come out of the exposure section at a symmetrical position against the substrate. The liquid recycling section is provided independently of the liquid supply section, the exposure section, and the liquid recovery section, or integrally provided with the liquid supply section and the exposure section.

In the present invention, it is preferable to use a saturated hydrocarbon compound or a saturated hydrocarbon compound including a silicon atom in its structure as the liquid. It is preferable that the liquid be an alicyclic hydrocarbon compound or a cyclic hydrocarbon compound including a silicon atom in its ring structure. As the alicyclic hydrocarbon compound or the cyclic hydrocarbon compound including a silicon atom in its ring structure, it is preferable to use compound having a transmittance of ArF laser light with a wavelength of 193 nm of 90% or more at an optical path length of 1 mm or a transmittance of KrF laser light with a wavelength of 248 nm of 90% or more at an optical path length of 1 mm.

In the present invention, it is preferable that the liquid supply section or the liquid recycling section include monitoring means for monitoring optical properties of the liquid transferred. It is preferable that the liquid recycling section include impurity removal means for removing impurities from the liquid recovered or transferred, and oxygen concentration control means for controlling oxygen concentration of the liquid recovered or transferred.

It is preferable that the impurity removal means include one or two or more of acid washing means for removing basic impurities from the liquid using an acid solution, alkali washing means for removing acidic impurities from the liquid using an alkaline solution, water washing means for removing impurities from the liquid using pure water, and distillation means for separating impurities from the liquid utilizing a difference in boiling point.

It is also preferable that the impurity removal means include column chromatography purification means for removing impurities from the liquid by passing through a column packed with an absorbent for adsorption chromatography. It is also preferable that the impurity removal means include at least one of distillation means for separating impurities from the liquid utilizing a difference in boiling point and filtration means for separating insoluble components from the liquid.

It is preferable that the monitoring means for monitoring the optical properties of the liquid include absorbance measuring means for monitoring absorbance of the liquid transferred online. It is preferable that the liquid supply section include degassing means for maintaining dissolved gas in the liquid at desired concentration, and temperature adjusting means for maintaining the liquid at desired temperature.

In the present invention, it is preferable that at least container and line used to return the liquid from the liquid recycling section to the liquid supply section be formed of materials without eluting any impurities. In the present invention, it is preferable that at least container and line used to return the liquid from the liquid recycling section to the liquid supply section be sealed with an inert gas. The liquid recycling section may be located away from location of the exposure section.

According to the present invention, there is provided method of recycling a liquid exposed at immersion exposure system or immersion exposure method which performs an exposure process through a liquid provided between an optical element of projection optical means and a substrate, the method comprising step A of recovering the liquid, step B of recycling the recovered liquid, and step C of introducing the recycled liquid into a space between the optical element of the projection optical means and the substrate and reusing the liquid.

In the present invention, it is preferable that the step B include step X of removing impurities from the recovered liquid and controlling oxygen concentration of the liquid, and step Y of maintaining dissolved gas in the liquid at desired concentration and maintaining the liquid at desired temperature.

According to the present invention, there is provided method of supplying a liquid for immersion exposure to an immersion exposure tool which performs an exposure process through a liquid provided between an optical element of projection optical means and a substrate, the method comprising monitoring optical properties of the liquid supplied to the immersion exposure tool, and supplying the liquid having optical properties within specific ranges.

In the present invention, it is preferable that the liquid having optical properties within specific ranges be always supplied to the immersion exposure tool by excluding the liquid of which the monitored optical properties are out of specific ranges. The monitored optical properties of the liquid include a transmittance at 193 nm and/or a refractive index at 23°C.

It is preferable to measure the optical properties of the liquid online when monitoring the optical properties of the liquid. It is preferable that the liquid be maintained in a specific temperature range in a liquid supply section which supplies the liquid and the immersion exposure tool to which the liquid is supplied. It is preferable to adjust the temperature of the liquid to a value within $\pm 0.1$°C of a set temperature.

In the method according to the present invention, it is preferable that the liquid of which the optical properties are monitored is a liquid which has been exposed in the immersion exposure tool at least once, and the liquid exposed at the immersion exposure tool is recycled so that the liquid has optical properties within specific ranges and the recycled liquid is again supplied to the immersion exposure tool. In this case, it is preferable that the recycling include a process of removing at least one kind of contaminants selected from impurities, gases, and particles from the liquid exposed at the immersion exposure tool.

It is preferable that the process of removing impurities include at least one kind of processes selected from a column chromatography purification process which removes impurities by passing through a column packed with an absorbent for adsorption chromatography, a distillation process which separates impurities from the liquid utilizing a difference in boiling point, a filtration process which separates insoluble components from the liquid, and a degassing process which removes gas from the liquid.

BRIEF DESCRIPTION OF THE DRAWINGS

FIG 1 is a schematic flow diagram showing one embodiment of an immersion exposure system according to the present invention.

FIG 2 is a schematic flow diagram showing another embodiment of an immersion exposure system according to the present invention.

FIG 3 is a schematic configuration diagram showing one embodiment of an exposure tool used in an immersion exposure system according to the present invention.

FIG 4 is a schematic flow diagram showing an example of an immersion exposure system for carrying out a method of supplying a liquid for immersion exposure according to the present invention.

FIG 5 is a schematic flow diagram showing another example of an immersion exposure system for carrying out a method of supplying a liquid for immersion exposure according to the present invention.

FIG 6 is a schematic flow diagram showing still another example of an immersion exposure system for carrying out a method of supplying a liquid for immersion exposure according to the present invention.

FIG 7 is a schematic flow diagram showing yet another example of an immersion exposure system for carrying out a method of supplying a liquid for immersion exposure according to the present invention.

BEST MODE FOR CARRYING OUT THE INVENTION

Embodiments of the present invention are described below. Note that the present invention is not limited to the following embodiments. Various alterations, modifications, and improvements may be made without departing from the scope of the present invention based on knowledge of a person skilled in the art.

The immersion exposure system according to the present invention includes at least a liquid supply section, an exposure section, a liquid recycling section, and optionally a liquid recovery section which recovers a liquid passed through the exposure section as the elements. The exposure section includes an immersion exposure tool as the main element. In one embodiment of the immersion exposure system according to the present invention, a liquid is continuously supplied from the liquid supply section to the exposure section, introduced into the space between an optical element of a projection optical means and a substrate, (continuously) discharged from the space between the optical element of the projection optical means and the substrate at a symmetrical position against the substrate in the exposure section, and transferred to the liquid recycling section. In another embodiment, the liquid is supplied to a local region between the optical element of the projection optical means and the substrate, and discharged from the local region. As examples of the above one embodiment, technologies disclosed in WO99/49504 and JP-A-2004-207711 can be given. As an example of the other embodiment, technology disclosed in JP-A-2004-343114 can be given.

In the immersion exposure system according to the present invention, the expression "the liquid recycling section is provided independently of the liquid supply section, the exposure section, and the liquid recovery section" means that the liquid recycling section is not integrated with the liquid supply section, the exposure section, and the liquid recovery section. Although the distance between the installation locations is not limited, it is necessary that at least the liquid recycling section and the liquid supply section and the liquid recovery section and the liquid recycling section not be connected through only a line (pipe). It is preferable that the liquid supply section, the exposure section, and the liquid recovery section be integrated, although this condition is not essential. Note that the distance among each section installed is not limited. It is necessary that at least the liquid supply section and the exposure section and the exposure section and the liquid recovery section be connected through a line (pipe).

In the immersion exposure system according to the present invention, the expression "the liquid recycling section is integrally provided with the liquid supply section and the exposure section" means that at least the liquid supply section and the exposure section and the exposure section and the liquid recycling section are connected through a line (pipe), and the distance among each section installed is not limited.

The immersion exposure tool forming the exposure section is an exposure tool which includes an illumination means for illuminating a master, a substrate holding means for holding a substrate on a stage, and a projection optical means for transferring a pattern of the master onto the substrate, wherein a space between the end of a substrate-side optical element of the projection optical means and the surface of the substrate is filled with a liquid. The term "master" refers to a mask or a reticle. The term "substrate" refers to a silicon wafer, a glass plate for display devices such as liquid crystal display devices, a ceramic wafer for thin-film magnetic heads, a master made of synthetic quartz or the like used for exposure devices, and the like. The projection optical means mainly includes a plurality of optical elements supported by a lens barrel. The optical element is generally a lens. The substrate holding means is not limited. It is preferable that the substrate holding means have a function of moving the substrate. The substrate holding means may be formed of a stage on which the substrate is placed, and a direct-movement system which may freely and accurately position the stage in three-dimensional directions. The immersion exposure tool forming the exposure section may be a step-and-repeat reduction projection-type exposure tool or a step-and-scan projection exposure tool which performs an exposure process while scanning a reticle and a wafer in synchronization. In the exposure section included in the immersion exposure system according to the present invention, exposure light (light source) for illuminating the master is not limited. ArF laser light (193 nm), KrF laser light (248 nm), F2 laser light (157 nm), or the like may be used. The exposure light may be an ultraviolet emission line from a mercury lamp (g line, h line, and i line).

In the immersion exposure system according to the present invention, as the liquid (liquid for immersion exposure) with which the space between the end of the substrate-side optical element of the projection optical means and the surface of the substrate is filled, a liquid organic compound with an preferable optimal refractive index and transmittance may be used. Other liquids may be suitable for immersion exposure. For example, the liquid may be suitable which tends to be affected by dissolved oxygen. The immersion exposure system according to the present invention is suitably used when the liquid is a saturated hydrocarbon compound or a saturated hydrocarbon compound including a silicon atom in its structure. The immersion exposure system according to the present invention is also suitably used when the liquid is an alicyclic hydrocarbon compound or a cyclic hydrocarbon compound including a silicon atom in its ring structure. As examples of the alicyclic hydrocarbon compound, decalin, trans-decahydronaphthalene, and exo-tetrahydrodicyclopentadiene can be given.

In the immersion exposure system according to the present invention, it is preferable that the alicyclic hydrocarbon compound or the cyclic hydrocarbon compound including a silicon atom in its ring structure have a transmittance of ArF laser light with a wavelength of 193 nm of 90% or more at an optical path length of 1 mm. The transmittance is more preferably 95% or more, and still more preferably 97% or more. It is preferable that the alicyclic hydrocarbon compound or the cyclic hydrocarbon compound including a silicon atom in its ring structure have a transmittance of KrF laser light with a wavelength of 248 nm of 90% or more at an optical path length of 1 mm. The transmittance is more preferably 95% or more, and still more preferably 97% or more. It is preferable that the alicyclic hydrocarbon compound or the cyclic hydrocarbon compound including a silicon atom in its ring structure have a refractive index of a D line of 1.4 or more. The refractive index is more preferably 1.4 to 2.0, and still more preferably 1.40 to 1.65.

The important feature of the present invention is that the liquid used in the exposure section is processed in the liquid recycling section to recover the properties (e.g. particles, impurities, refractive index, absorbance, temperature, and viscosity) of the liquid (recycling), the absorbance and/or the refractive index of the liquid are monitored, the liquid having an absorbance and/or a refractive index within a specific range is transferred to the exposure section and used (reused), and the liquid having an absorbance and/or a refractive index out of a specific range (out-of-specification) is removed and purified by off-site recycling (chemical purification).

In the present invention, it is preferable that the liquid supply section or the liquid recycling section include monitoring means for monitoring the absorbance (transmittance) and/or the refractive index (optical properties) of the transferred liquid. It is preferable that the liquid supply section or the liquid recycling section include at least the monitoring means for measuring and monitoring the absorbance. It is preferable that the absorbance (transmittance) monitoring means monitor the absorbance (transmittance) of the liquid online, and the refractive index monitoring means control the refractive index of the liquid online to at least five decimal places. Whether or not the liquid has specific optical properties is measured using the monitoring means. When the liquid has specific optical properties, the liquid is reused in the exposure section. It is preferable to control the refractive index within the range of $\pm 0.0001$, and particularly preferably $\pm 0.00001$ at specific temperature.

It is preferable that the liquid recycling section according to the present invention include an impurity removal means for removing impurities, gas, and/or particles from the transferred liquid. Specifically, impurities are removed from the liquid of which the purity is decreased by exposure and which contains impurities such as reaction byproducts and components of the resist film to recycle the liquid. It is preferable that the impurity removal means include a column chromatography purification means for removing impurities from the liquid by passing through a column packed with an absorbent for adsorption chromatography due to high removal efficiency. As the absorbent used for the column chromatography purification means, silica gel, alumina, zeolite, an ion-exchange resin, activated carbon, diatomaceous earth, titania, zirconia, and the like can be given. It is preferable to use any one of silica gel, alumina, or zeolite. It is preferable that impurities such as water be removed from the absorbent by heating at 100 to 300°C for 24 hours under a vacuum of 5 mmHg or less.

It is also preferable that the impurity removal means include at least one of a distillation means for separating impurities from the transferred liquid utilizing a difference in boiling point and a filtration means for separating insoluble components from the transferred liquid in addition to the column chromatography purification means in order to more sufficiently remove impurities from the liquid in which various impurities are mixed. As the distillation means, a molecular distillation method, a membrane distillation method, and the like can be given. It is desirable to apply a means which separates impurities at a distillation temperature of 50°C or less under a vacuum of 3 mmHg or less based on the difference in boiling point between the impurities to be removed and the liquid for immersion exposure.

In the present invention, impurities are removed from the liquid using the impurity removal means such as the column chromatography purification means, the distillation means, and the filtration means, as described above. However, it is very difficult to completely remove impurities from the liquid even when being purified by applying these impurity removal means. Specifically, since PAG, acid, amine, resist decomposed product, and the like leached (extracted) from the resist film to the liquid are highly polar compounds, these compounds are adsorbed on the absorbent for adsorption chromatography and can be easily removed. On the other hand, since a photodecomposed compound generated during exposure has a nonpolar nature the same as the liquid do, the compound is hard to adsorb on the absorbent for adsorption chromatography and partially remains in the liquid. Therefore, the liquid exposed is not completely refined in the liquid recycling section, and the absorbance of the liquid gradually increases along with circulation numbers. In the present invention, when the absorbance monitored online by the absorbance measuring means exceeds a specific value in the liquid supply section, the tank is switched to a purification tank.

For filtration, a method using an appropriate filter can be given. As the filter, it is preferable to use a filter formed of a material which exhibits excellent microparticle removal efficiency and does not show a change in absorption at an exposure wavelength due to any leaching during filtration. As examples of a preferred material for the filter, glass, ceramic, metals such as stainless steel (e.g. 304SUS) and titanium, a fluororesin, and the like can be given. A fluororesin material is a more preferred material due to low leaching properties. As examples of the fluororesin material, perfluoroalkoxy (PFA), polytetrafluoroethylene (PTFE), perfluoroethylenepropylene (PFEP), and ethylene-chlorotetrafluoroethylene (ECTFE), and the like can be given. It is preferable that the materials for peripheral parts of the filter such as the housing, core, support, and plug be selected from the above preferred materials for the filter. The pore size of the filter is preferably 0.2 micrometers or less, more preferably 0.1 micrometers or less, and particularly preferably 0.05 micrometers or less.

It is preferable that the liquid supply section include a degassing means for maintaining dissolved gas in the liquid at desired concentration, temperature adjusting means for maintaining the liquid at desired temperature, and a filtration means for removing impurities from the liquid.

A specific method for the degassing means is not limited. A method may be used which can remove all gases including oxygen and an inert gas such as a nitrogen gas used when enclosing the liquid in a container, for example. In particular, since oxygen absorbs light with the exposure wavelength such as ArF laser light or KrF laser light, it is desirable to remove oxygen so that the amount of oxygen dissolved in the liquid is 3 mg/L (ppm), and preferably 1 mg/L (ppm) at 20°C and 1 atm, for example. For example, when hermetically enclosing an inert gas in the container and the line for transferring the liquid, the inert gas may exist (dissolve) in a supersaturation state due to the pressure in the container and the line, and cause bubbles in the immersion exposure tool (exposure section) during use of the liquid. Therefore, it is preferable to also remove the inert gas in order to prevent pattern defects which may occur due to bubbles during exposure. Therefore, a degassing means is used which can remove all gases including oxygen. As examples of the degassing means, a reduced pressure degassing method, an ultrasonic degassing method, a degassing method using a gas permeable membrane (without using inert gas), and the like can be given. It is preferable to remove the enclosed inert gas, as described above, although the inert gas may not be removed. Since it is necessary to remove the inert gas before exposure, it is desirable to set up the liquid supply section equipped with means for removing gas dissolved in the liquid including inert gas (degassing means) near the exposure section.

In order to keep the optical characteristics (e.g. refractive index) of the liquid constant, it is preferable that the temperature adjusting means is a means which can control the temperature of the liquid within the range of ±0.2°C prior to exposure, i.e., when the space between the optical element of the projection optical means and the substrate in the immersion exposure tool. The temperature adjusting means more preferably adjusts the temperature within the range of ±0.1°C, still more preferably ±0.05°C, and particularly preferably ±0.01°C. For example, the temperature adjusting means includes a container which stores the liquid and a heat insulating material which covers the container, wherein the container has a function of serving as a heater and a cooler by circulating a refrigerant or the like. It is desirable to apply a means which can control the temperature of the liquid within the above range with respect to the temperature (e.g. 23°C) of a clean room or the temperature (23°C) in the exposure section (immersion exposure tool).

In the immersion exposure system according to the present invention, it is preferable that the liquid be transferred between the liquid recycling section and the liquid supply section and between the liquid recovery section and the liquid recycling section using a container.

It is preferable that the liquid recycling section include an impurity removal means for removing impurities from the recovered liquid, and an oxygen concentration control means for controlling the oxygen concentration of the recovered liquid. In this case, the term "recycling" in the liquid recycling section means removing impurities from the liquid (purification) and controlling the oxygen concentration.

In the immersion exposure system according to the present invention, it is preferable that at least a container and a line for returning the liquid from the liquid recycling section to the liquid supply section are made of a material without any leaching. It is more preferable that a container and a line for transferring the liquid introduced into the liquid recovery section to the liquid recycling section are also made of a material without any leaching. This is because the liquid can be prevented from contamination of impurities during transfer.

The container and the line used herein mean the entire path through which the liquid is returned to the liquid supply section from the liquid recycling section (this also applies to the case of hermetically enclosing inert gas). The term "material without any leaching" refers to material which is not easily dissolved (leached) in the immersion exposure liquid used. In general, glass, ceramic, metals such as stainless steel (e.g. 304SUS) and titanium, a fluororesin, and the like may be used, although the material differs depending on the liquid. A fluororesin material is a more preferred material without any leaching. As examples of the fluororesin material, perfluoroalkoxy (PFA), polytetrafluoroethylene (PTFE), perfluoroethylenepropylene (PFEP), and ethylene-chlorotetrafluoroethylene (ECTFE), and the like may be used.

In the immersion exposure system according to the present invention, it is preferable that at least a container and a line used to return the (recycled) liquid from the liquid recycling section to the liquid supply section be sealed with an inert gas. It is more preferable that at least a container and a line used to transfer the liquid introduced into the liquid recovery section to the liquid recycling section be also sealed with an inert gas. This prevents gas such as air from being dissolved in during transfer, thereby saving time for the impurity removing means and the oxygen concentration control means in the liquid recycling section and the degassing means in the liquid supply section.

The container (e.g. tank) is generally sealed with an inert gas at a low pressure without opening the line (e.g. pipe). As the inert gas, nitrogen, argon, or helium may be used. Of these, nitrogen is preferably used due to low cost. The inert gas dissolved in the liquid is removed by the degassing means in the liquid supply section before being transferring to the exposure section.

In the immersion exposure system according to the present invention, it is preferable that the impurity removal means in the liquid recycling section include one or two or more of an acid washing means for removing basic impurities from the liquid using an acid solution, an alkali washing means for removing acidic impurities from the liquid using an alkaline solution, a water washing means for removing impurities from the liquid using pure water, and a distillation means for separating impurities from the liquid utilizing a difference in boiling point.

When the immersion exposure system according to the present invention includes an oxygen concentration control means, it is preferable that the oxygen concentration control means distil the recovered liquid using a reduced pressure distillation method or the like to control the oxygen concentration of the liquid at about 10 ppm.

When the liquid is an alicyclic hydrocarbon compound or a cyclic hydrocarbon compound including a silicon atom in its ring structure, it is preferable that the immersion exposure system according to the present invention include all of the above impurity removing means. It is more preferable that the immersion exposure system further include a filtration means, a dehydrating means, and the like. When the immersion exposure system include all of the above impurity removing means, it is preferable that the liquid recycling section process the liquid in order of the acid washing means, the alkali washing means, the water washing means, the dehydrating means, the distillation means, the filtration means, and the oxygen concentration control means. The liquid from which impurities have been removed and of which the oxygen concentration has been controlled is stored in a transfer tank, a container, and the like.

As an example of the acid solution acid used in the washing means, concentrated sulfuric acid (98 mass%) can be given. As an example of the alkali solution used in the alkali washing means, a sodium hydrogen carbonate aqueous solution (0.01 to 12 mass%) can be given. It is preferable that the distillation means use a precision distillation method at a distillation temperature of 30 to 300°C using a distillation column having a number of theoretical plates equal to or greater than that necessary for separation based on the difference in boiling point between removal target impurities and the liquid for immersion exposure.

In the immersion exposure system according to the present invention, the liquid recycling section may be set up in the same area (e.g. factory) as the exposure section and the liquid supply section. In a system in which the exposed liquid is recycled in a remote location, the cost of the liquid increases along with an increase in liquid transportation cost, factory operation cost, and labor costs. The liquid recycling section may be set up in a location away from the exposure section.

Since the location of the exposure section is a location where exposure tool is set up (i.e. production line in the factory), the remote location corresponds to a location outside the factory or another location in the factory. It is preferable the liquid recycling section is set up in a remote location because the alicyclic hydrocarbon compound usually has a low flash point. Compared to the flash point of the alicyclic hydrocarbon compound, which is about 60°C, it is considered that the alicyclic hydrocarbon compound does not ignite and a fire does not usually occur at a room temperature (about 23°C). However, it is possible for the liquid of immersion exposure to ignite in comparison with pure water and the like. Therefore, that cause suspension of a semiconductor/liquid crystal production line which requires a clean and a significant start-up time. Accordingly, it is desirable to isolate the liquid recycling section from the production line taking the damage into consideration. It is desirable to supply only a necessary amount of liquid to the immersion exposure tool in the production line (exposure section) off-line.

When the liquid recycling section is set up away from the exposure section and the like, since between the liquid recycling section and the liquid supply section, or between the liquid recovery section and the liquid recycling section are not connected through a line (e.g. pipe), it is necessary to store the liquid in the transfer container and transport the container. Therefore, it is desirable to prevent oxygen gas in the air from dissolving the container by using a simple joint (quick joint) or the like for connecting the container and the line so that leakage of inert gas does not occur when separating the container (e.g. transfer tank) from the line (e.g. pipe). It is important to use a connection method which does not cause the liquid for immersion exposure to react when connecting the pipe and the like.

According to the present invention, there is provided a method of recycling a liquid used for an immersion exposure system or an immersion exposure method which includes an exposure process through a liquid provided between an optical element of projection optical means and a substrate, the method comprising a step A of recovering the liquid, a step B of recycling the recovered liquid, and a step C of introducing the recycled liquid into a space between the optical element of the projection optical means and the substrate and reusing the liquid (hereinafter also called "recycling method according to the present invention").

In the method of recycling a liquid according to the present invention, it is preferable that the step B include a step X of removing impurities from the recovered liquid and controlling oxygen concentration of the liquid, and a step Y of maintaining the liquid at desired dissolved gas concentration and maintaining the liquid at desired temperature.

In the method of recycling a liquid according to the present invention, it is preferable that the liquid used in the immersion exposure tool be recycled so that the liquid has optical properties within specific ranges and the recycled liquid be again supplied to the immersion exposure tool. In this case, it is preferable that the recycling include a process of removing at least one of impurities, gases, and particles from the liquid passed through the immersion exposure tool.

In the method of recycling a liquid according to the present invention, it is preferable that the process of removing impurities include at least one of column chromatography purification which removes impurities by causing the transferred liquid to pass through a column packed with an absorbent for adsorption chromatography, distillation which separates impurities from the transferred liquid utilizing a difference in boiling point, filtration which separates insoluble components from the transferred liquid, and degassing which removes gas from the transferred liquid.

Specifically, in one preferred embodiment of the method of supplying an immersion exposure liquid according to the present invention, the liquid transferred from the immersion exposure tool is recycled to recover the properties (e.g. particles, impurities, refractive index, transmittance, temperature, and viscosity) of the liquid, the absorbance and/or the refractive index of the liquid supplied to the immersion exposure tool are monitored, only the liquid having an absorbance and/or a refractive index within a specific range is supplied used (used), and the liquid having an absorbance and/or a refractive index outside a specific range (out-of-specification) is removed without supplying the liquid to the immersion exposure tool, subjected to chemical purification including recycling on-site (the same area (e.g. factory) as the exposure device) or off-site (remote location) so that the absorbance and/or the refractive index of the liquid supplied fall within a specific range. The recycling process is more preferably performed on-site. When performing the recycling process off-site, the cost of the liquid increases due to an increase in liquid transportation cost, factory operation cost, and labor costs.

As described above, since the immersion exposure system according to the present invention employs the immersion method, the depth of focus of an image of the pattern of a master can be increased by about n times the depth of focus (n is the refractive index of the liquid) in the air, whereby the pattern of a minute circuit and the like can be stably transferred with a high resolution (effects of immersion method).

In the immersion exposure system according to the present invention, the liquid (liquid for immersion exposure) used in the exposure section and introduced into the liquid recovery section is recycled by the impurity removing means (including distillation, if necessary) and the oxygen concentration control means in the liquid recycling section, and the recycled liquid is returned to the liquid supply section including the degassing means and the temperature adjusting means and reused. Therefore, the repeat use of the liquid can result in reduction of running cost, whereby competitiveness of semiconductor/liquid crystal production and the like can be improved. Moreover, it is unnecessary to discard the liquid. Even if the liquid is repeatedly used, since oxygen and other gases are removed from the liquid and the amount of light absorbed during exposure through the liquid is extremely small, a variation in focus caused by an increase in temperature of the liquid and a change in refractive index of the liquid are minimized, whereby the effects of the immersion method can be maintained. As a result, the pattern of the master can be accurately transferred onto the substrate. Moreover, since the components of the resist film dissolved in the liquid due to contact with the resist film are removed using the column chromatography purification means, the amount of light reaching the resist (film) is constant. Moreover, the transfer rate is not decreased so that exposure throughput in terms of wafers processed per unit time is maintained at least according to the plan (design) and does not change during exposure. Specifically, the liquid having specific properties is circulated and used by monitoring the properties of the liquid online while recycling the liquid, whereby exposure can be continuously performed. Therefore, the yield of electronic devices with minute dimensions can be significantly improved, whereby manufacturing efficiency can be further improved.

In a preferred embodiment of the immersion exposure system according to the present invention, an alicyclic hydrocarbon compound or a cyclic hydrocarbon compound including a silicon atom in its ring structure is repeatedly used as the liquid for immersion exposure. Therefore, an optical system with a large numerical aperture (NA) can be realized as compared with pure water, whereby the resolution can be improved. Moreover, the depth of focus can be further increased as compared with pure water. Therefore, even if the pattern of the master of circuits and the like is reduced in size, the pattern can be stably transferred onto the substrate with a high resolution. Since the alicyclic hydrocarbon compound exhibits extremely low reactivity with a conventional resist material and calcium fluoride, pattern defects after development and contamination of the lens due to dissolution of acids and the like from the resist film which may cause a problem when using pure water can be minimized (see NIKKEI MICRODEVICE, April 2004, page 77). Therefore, the yield of electronic devices can be improved, and work and cost for protection and maintenance of the immersion exposure tool can be reduced.

In a preferred embodiment of the immersion exposure system according to the present invention, since the container and the line used to return the liquid from the liquid recycling section to the liquid supply section is made of a material without any leaching and sealed with an inert gas, at least the recycled liquid is not contaminated due to dissolution of gas including oxygen, impurities, and the like. Therefore, the above-mentioned effect of continuously performing exposure while reducing running cost can be stable obtained.

Since the immersion exposure system according to the present invention includes the impurity removing means including the acid washing means, the alkali washing means, the water washing means, the distillation means, the column chromatography purification means, the filtration means, and the like and can remove impurities from the used liquid, about 80% of the liquid can be repeatedly used. Therefore, running cost can be reduced when the liquid is an alicyclic hydrocarbon compound or a cyclic hydrocarbon compound including a silicon atom in its ring structure. Moreover, it becomes unnecessary to discard the liquid (organic substance), whereby environment can be protected. Since impurities have been removed from the liquid, absorption of (exposure) light due to impurities during exposure through the liquid are minimized even if the liquid is repeatedly used. Moreover, a variation in focus caused by an increase in temperature of the liquid and a change in refractive index of the liquid are minimzed, whereby the effects of the immersion method can be maintained. As a result, the pattern of the master can be accurately transferred onto the substrate. Moreover, since the amount of light reaching the resist (film) is not decreased, exposure throughput in terms of wafers processed per unit time is maintained at least according to the plan (design). Specifically, the properties of the liquid can be controlled within a specific range during recycl, whereby exposure can be continuously performed. Therefore, the yield of electronic devices with minute dimensions can be significantly improved, whereby manufacturing efficiency can be further improved.

In a preferred embodiment, the immersion exposure system according to the present invention includes the monitoring means for monitoring the optical properties of the recycled liquid. Therefore, a process/operation can be selected in which the recovered liquid is not necessarily transferred from the liquid recovery section to the liquid recycling section when the optical properties are controlled within a specific range, is returned from the liquid recovery section to the liquid supply section only filtering particles, the liquid is recycled after degassing and temperature adjustment of the liquid supply section, and impurities are removed from the liquid (purification) when the optical properties are out of a specific range. This makes it possible to optimize the quality of the recycled liquid and recycling cost.

Since the immersion exposure liquid recycling system according to the present invention recovers the liquid used in the immersion exposure tool (step A), preferably removes impurities from the liquid and controls the oxygen concentration (step X), recycles the liquid (step B) by maintaining the concentration of gas dissolved in the liquid at a desired value and maintaining the temperature of the liquid at a desired value (step Y), and reuses the liquid (step C), 80% of the liquid can be repeatedly used, and running cost can be reduced. Moreover, it becomes unnecessary to discard the liquid.

In the method of recycling an immersion exposure liquid according to the present invention, since the optical properties of the liquid supplied to the immersion exposure tool are monitored and the liquid has optical properties within specific ranges is supplied, the properties of the liquid can be controlled to ensure continuous exposure.

In particular, when recycling the used liquid without monitoring the optical properties of the liquid, defective exposure is likely to occur. Specifically, even if impurities are removed from the liquid by the impurity removing process such as the column chromatography purification process, the distillation process, and the filtration process, it is very difficult to completely remove impurities from the liquid. Specifically, since PAG, acid, amine, resist decomposed product, and the like leached (extracted) from the resist film to the liquid are highly polar compounds, these compounds are adsorbed on the absorbent for adsorption chromatography and can be easily removed. On the other hand, since a photodecomposed compound generated during exposure has a nonpolar nature the same as the liquid does, the compound is hard to adsorb the absorbent for adsorption chromatography and partially remains in the liquid. Specifically, the liquid after exposure cannot be completely recycled. When circulating and reusing the liquid, the transmittance of the liquid gradually increases, whereby defective exposure may occur. In the method of recycling an immersion exposure liquid according to the present invention, since the transmittance is preferably monitored, such a problem can be minimized.

In the method of supplying an immersion exposure liquid according to the present invention, since the optical properties of the liquid supplied to the immersion exposure tool are monitored and the liquid has optical properties within specific ranges is supplied, the liquid used can be recycled by only removing gas from the liquid, removing particles from the liquid (filtration), and adjusting the temperature when the optical properties are controlled within a specific range. When the optical properties are out of a specific range, a process/operation of removing impurities from the liquid can be selected. This makes it possible to continuously use the liquid until the quality limit. This makes it possible to reduce running cost while maintaining manufacturing efficiency, whereby the quality of the recycled liquid and recycling cost can be optimized.

The present invention is described below with reference to the drawings. It should be understood that the present invention is not limited to the following embodiments. Various modifications, alterations, and improvements may be made without departing from the scope of the present invention based on knowledge of a person having an ordinary skill in the art. For example, although the drawings represent preferred embodiments of the present invention, the present invention is not limited to the embodiments illustrated in the drawings or information provided in the drawings. Although the present invention may be practiced or verified by applying means similar or equivalent to the means described herein, preferred means are means described below.

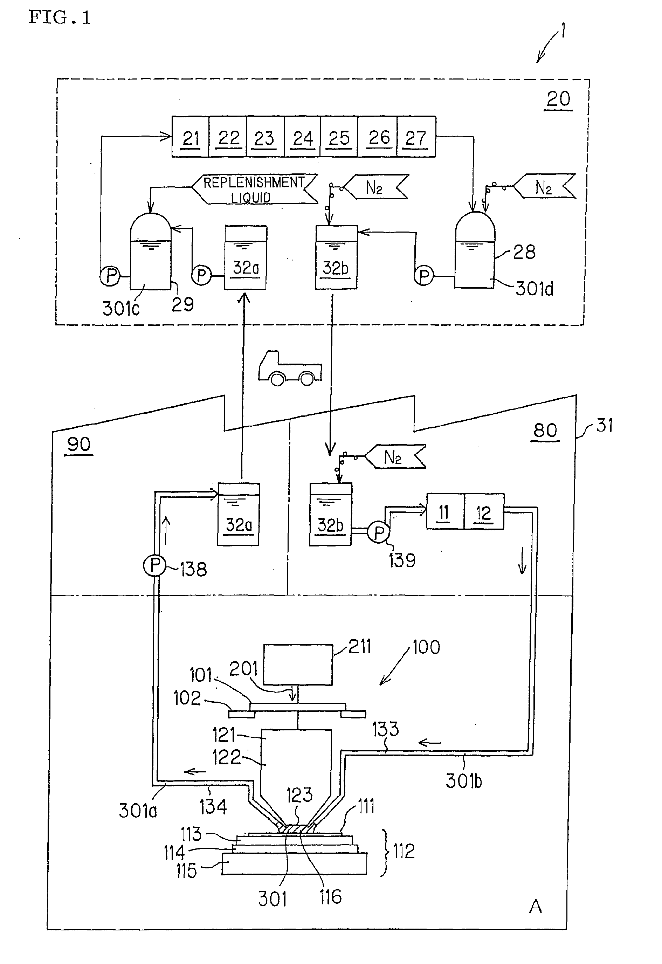

FIG 1 is a schematic flow diagram showing one embodiment of an immersion exposure system according to the present invention. The elements and the operation of an immersion exposure system 1 shown in FIG. 1 and a method of recycling a liquid according to the present invention are described below.

The entire configuration of the immersion exposure system 1 is as follows. The immersion exposure system 1 is a system which performs an exposure process through a liquid 301 provided between an optical element of a projection optical means 121 and a substrate 111, wherein the liquid 301 is circulated. As the liquid 301, an alicyclic hydrocarbon compound (e.g. decalin, trans-decahydronaphthalene, or exo-tetrahydrodicyclopentadiene) is used which has a refractive index n at a wavelength 193 nm of 1.64 (when the temperature of the liquid is 23°C) and a transmittance at a wavelength of 193 nm of 90% or more when converted to an optical path length of 1 mm.

The immersion exposure system 1 includes an exposure section A, a liquid supply section 80, and a liquid recovery section 90 provided in the area of a factory 31, and a liquid recycling section 20 provided in a location apart from the factory 31. The (recycled) liquid 301 (301b) is supplied to the exposure section A from the liquid supply section 80, and introduced into the space between the optical element of the projection optical means 121 and the substrate 111 in the exposure section A. The liquid 301 is come out of the space between the optical element of the projection optical means 121 and the substrate 111 at a symmetrical position against the substrate 111, and introduced into the liquid recovery section 90 (step A of the recycling method according to the present invention).

The recovered liquid 301 (301a) is supplied to the liquid recycling section 20 from the liquid recovery section 90. In the liquid recycling section 20, impurities are removed from the liquid 301 (301c) supplied to the liquid recycling section 20, and the oxygen concentration of the liquid is controlled (step X (part of step B) of the recycling method according to the present invention). The liquid 301 (301c) from which impurities have been removed and of which the oxygen concentration has been controlled is subjected to a necessary optical constant inspection, and the liquid 301 which has passed inspection is supplied to the liquid supply section 80. The term "necessary optical constant inspection" refers to a refractive index measurement at a wavelength of 193 nm conducted at a temperature of 23°C, transmittance measurement using a 1 cm measurement quartz cell, viscosity measurement, and the like. In the liquid supply section 80, the liquid 301 is degassed and is subjected to temperature adjustment (step Y (part of step B) of the recycling method according to the present invention). The (recycled) liquid 301 (301b) is supplied to the exposure section A from the liquid supply section 80, and reused (step C of the recycling method according to the present invention).

The exposure section A is described below. The main element of the exposure section A is an immersion exposure tool 100 which performs an exposure process. The immersion exposure tool 100 includes a master holding means 102 for supporting a master 101 (mask), a substrate holding means 112 (stage) for supporting the substrate 111 to which a resist is applied in advance, an illumination means 211 for illuminating the master 101 supported by the master holding means 102 with exposure light 201, and a projection optical means 121 for projecting an image of the pattern of the master 101 illuminated by the exposure light 201 onto the substrate 111 supported by the substrate holding means 112.

The illumination means 211 illuminates the master 101 supported by the master holding means 102 with the exposure light 201. The exposure light 201 emitted from the illumination means 211 is ArF laser light (wavelength: 193 nm), for example. The master holding means 102 supports the master 101. The position of the master 101 on the master holding means 102 is measured in real time using a laser interferometer or the like so that the master 101 is accurately positioned at a specific position. The projection optical means 121 projects the pattern of the master 101 onto the substrate 111 at a specific projection magnification (e.g. less than 1), and includes a plurality of optical elements (lenses) supported by a lens barrel 122 formed of stainless steel, for example. An end 123 of the projection optical means 121 is formed of an optical element and part of the lens barrel 122 holding the optical element. The substrate holding means 112 supports the substrate 111. The substrate holding means 112 is a direct-driven system including a Z stage 113 holding the substrate 111, an XY stage 114 supporting the Z stage 113, and a base 115 supporting the XY stage 114. The substrate holding means 112 is freely and accurately positioned and driven in three-dimensional directions by a driving device (not shown).

In the immersion exposure tool 100, the space between the surface of the substrate 111 and the end 123 of the projection optical means 121 is filled with the liquid 301. The lens barrel 122 and the optical element supported by the lens barrel 122 are partially disposed on the end 123 of the projection optical means 121 so that the liquid 301 contacts part of the optical element and the lens barrel 122.

The liquid 301 (301b) is supplied from the liquid supply section 80, and introduced into the space between the surface of the substrate 111 and the end 123 of the projection optical means 121 according to the following operation. The liquid 301 (301b) is continuously introduced into a space 116 between the end 123 of the projection optical means 121 and the substrate 111 along a specific direction through a supply pipe 133 made of stainless steel (e.g. 304SUS) of which the inner surface is subjected to a passivation treatment to suppress elution. The supply pipe 133 may be made of a fluororesin exhibiting excellent chemical resistance. The continuously introduced liquid 301 is come out of the space 116 between the end 123 of the projection optical means 121 and the substrate 111 at a symmetrical position against the substrate 111, and introduced into the liquid recovery section 90 through a recovery pipe 134. The space 116 between the end 123 of the projection optical means 121 and the substrate 111 is filled with the liquid 301 by equalizing the amount of the liquid 301 introduced into the space 116 through the supply pipe 133 per unit time and the amount of the liquid 301 come out of the space 116 through the recovery pipe 134 per unit time. Specifically, the liquid 301 does not remain stationary between the surface of the substrate 111 and the end 123 of the projection optical means 121, but is provided between the surface of the substrate 111 and the end 123 of the projection optical means 121 while always being replaced with new (recycled) liquid.

The above operation is implemented by causing the recycled liquid 301 (301b) to be supplied from the liquid supply section 80 under pressure and causing the liquid 301 (301a) come out of the space 116 to be sucked into the liquid recovery section 90. It suffices that the immersion exposure system according to the present invention be a system which performs an exposure process in a state in which the space between the surface of the substrate and the end of the projection optical means is filled with the liquid. The means for filling the space between the surface of the substrate and the end of the projection optical means with the liquid is not limited to the above operation, but may be a means or operation using another mechanism. The immersion exposure system according to the present invention does not exclude a system which performs an exposure process in a state in which the liquid remains stationary in the space between the surface of the substrate and the end of the projection optical means.

The liquid recovery section 90 is described below. A tank (container) 32a containing the liquid 301 is installed in the liquid recovery section 90 so that the tank 32a can be replaced with another tank. The tank 32a is made of stainless steel (e.g. 304SUS) and has an inner surface subjected to a passivation treatment to suppress elution. A tank (container) of which the inner wall is coated with a fluororesin material or a tank (container) coated with a metal which suppresses the entrance of oxygen (e.g. aluminum or copper) may also be used.

The liquid recovery section 90 includes a suction pump 138 for supplying the liquid 301 (301a) from the exposure section A (immersion exposure tool 100) to the tank 32a. The liquid 301 (301a) introduced into the space 116 is come out of the space 116 by being sucked up by the suction pump 138, and introduced into the tank 32a (preferably) sealed with nitrogen ($N_2$) (not shown) through the recovery pipe 134 (step A of the recycling method according to the present invention). The recovered liquid 301 (301a) is transferred to the liquid recycling section 20 together with the tank 32a. If impurities leached from a resist film, a top coating film, and the like formed on the substrate 111 are dissolved in the liquid 301 (301a) used for exposure for various reasons, the liquid 301 (301a) exhibits change of refractive index and transmittance and cannot be directly reused for exposure.

The liquid recycling section 20 is described below. The liquid recycling section 20 includes an acid washing means 21, an alkali washing means 22, a water washing means 23, a drying means 24, a distillation means 25, a filtration means 26, and an oxygen concentration control means 27, wherein the liquid 301 (301c) supplied to the liquid recycling section 20 is recycled (step X (part of step B) of the recycling method according to the present invention).

In the liquid recycling section 20, the liquid 301 (301c) is transferred from the transfer tank 32a to a stationary tank 29, basic impurities are mainly removed from the liquid 301 (301c) using the acid washing means 21, and aromatic compounds, carbon-carbon unsaturated compounds, and basic impurities with a large absorption of light with a wavelength of 193 nm are further removed. In the acid washing means 21, concentrated sulfuric acid (98 mass%) is injected into the liquid 301 (301c) at a volume ratio of about 25%, and the mixture is sufficiently stirred at room temperature for about 60 minutes, for example. The concentrated sulfuric acid is then removed from the liquid 301 (301c) by separation. This operation is repeated three times to separate the mixture into an organic layer (liquid 301) and another layer. The organic layer is then removed and supplied to the alkali washing means 22.

The alkali washing means 22 mainly removes acidic impurities. In the alkali washing means 22, a sodium hydrogen carbonate aqueous solution is injected into the organic layer obtained by the acid washing means 21, and the mixture is sufficiently stirred at room temperature, for example. The sodium hydrogen carbonate aqueous solution is then removed from the organic layer by separation. This operation is repeated three times. The organic layer subjected to alkali washing is then supplied to the water washing means 23.

In the water washing means 23, pure water is injected into the organic layer subjected to alkali washing, and the mixture is sufficiently stirred at room temperature, for example. The pure water is then removed from the organic layer. This operation is repeated a number of times. The organic layer is then supplied to the dehydrating means 24, and dehydrated over magnesium sulfate or the like, for example. After removing the magnesium sulfate by decantation, the resulting product is supplied to the distillation means 25. In the distillation means 25, the organic layer is separated using a precision distillation tool at a temperature of 60°C and a reduced pressure of 10 mmHg, for example. The organic layer is then filtered through the filtration means 26 including a filter.

The oxygen concentration and the like have been decreased by the distillation means 25. The oxygen concentration is measured using the oxygen concentration control means 27 and controlled to a value equal to or less than a desired value. Specifically, only the liquid 301 (301d) having an oxygen concentration equal to or less than a desired value is introduced into a tank 32b for transferring the liquid 301 from the stationary tank 28 to the liquid supply section 80. The tank 32b is sealed with an inert gas such as nitrogen so that gas such as oxygen is not dissolved in, and stored in a container or the like. The refractive index and the transmittance (particularly transmittance) are then measured, if necessary. After confirming that the refractive index and the transmittance are within desired ranges, the tank 32b is transferred to the liquid supply section 80 provided in the factory 31. When the oxygen concentration is higher than a desired value as a result of oxygen concentration measurement using the oxygen concentration control means 27, the liquid is returned to the tank 29, for example.

The liquid supply section 80 is described below. The tank (container) 32b containing the (recycled) liquid 301 is installed in the liquid supply section 80 so that the tank 32b can be replaced. The tank 32b is made of stainless steel (e.g. 304SUS) and has an inner surface subjected to a passivation treatment to suppress elution. A tank (container) of which the inner wall is coated with a fluororesin material or a tank (container) coated with a metal which suppresses the dissolution of oxygen (e.g. aluminum or copper) may also be used.

The liquid supply section 80 includes a pressure pump 139 for supplying the recycled liquid 301 from the tank (container) 32b to the exposure section A (immersion exposure tool 100), a degassing means 11 for removing gas from the liquid 301, and a temperature adjusting means 12 for adjusting the temperature of the liquid 301. As the degassing means 11, a vacuum membrane degassing tool without using an inert gas is used, for example. The temperature controlling means 12 may be formed using a container provided with an electric heater (heater) and a refrigerant circulation pipe (cooler), for example. Gases dissolved in the recycled liquid 301 are completely removed using the degassing means 11, and the temperature of the recycled liquid 301 is controlled to a specific value using the temperature controlling means 12 (step Y (part of step B) of the recycling method according to the present invention). The liquid 301 is again supplied as the liquid 301 (301b) to the exposure section A through the supply pipe 133 due to the pressure of the pressure pump 139, and the liquid 301 (301b) is introduced into the space 116 between the end 123 of the projection optical means 121 and the substrate 111 in the exposure section A, and reused (step C of the recycling method according to the present invention). The temperature of the liquid 301 is usually controlled to the temperature of a clean room in which the exposure device is installed (e.g. 23±0.1°C). Since the refractive index of the liquid 301 has a temperature dependence, the temperature of the liquid 301 to be supplied is controlled in the liquid supply section 80 and the exposure section A so that the temperature of the liquid 301 supplied to the space 116 is preferably 23±0.1°C, more preferably 23±0.05°C, and particularly preferably 23±0.01°C. As the temperature controlling means, a means can be given which air-conditions the environment of the liquid supply section 80 and the exposure section A (room in which the constituent instruments are installed) and includes an electric heater (heater) and a refrigerant circulation pipe (cooler) in each tank, for example.

A monitoring means for measuring and monitoring the refractive index and the transmittance of the liquid 301 in the tank 32b may be provided in the liquid supply section 80. The refractive index and the transmittance of the liquid 301 can be continuously measured by providing the monitoring means. When it is evaluated that impurities are contained in the liquid 301 based on the measured refractive index and transmittance and the liquid 301 is insufficiently recycled for exposure, the supply of the liquid 301 to the exposure section A is terminated. The liquid 301 is then transferred to the liquid recycling section 20 together with the tank 32b, and replaced with another liquid 301 (301d) recycled in the liquid recycling section 20 together with the tank 32b.

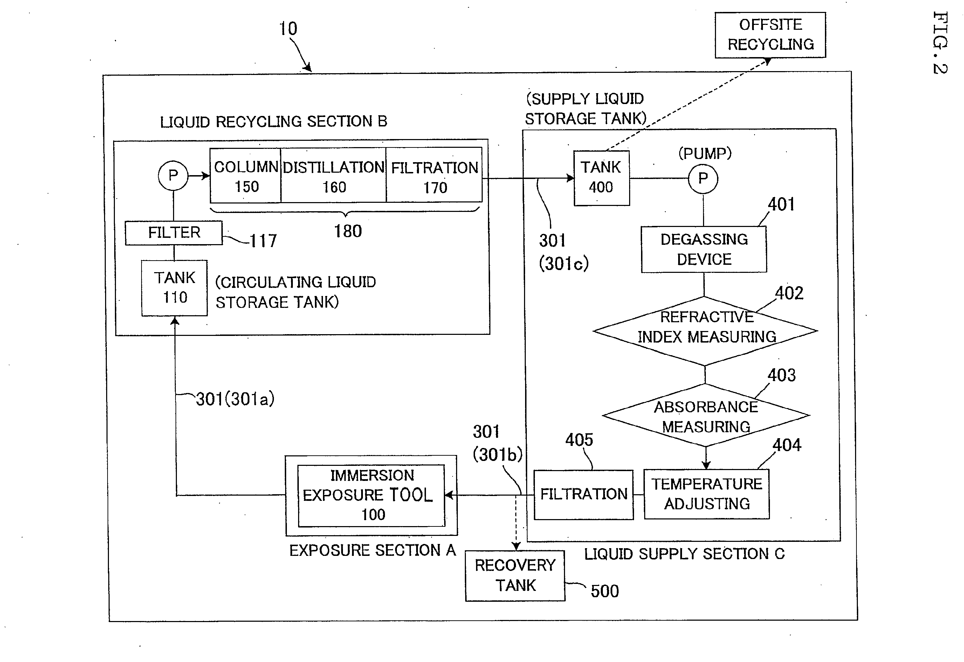

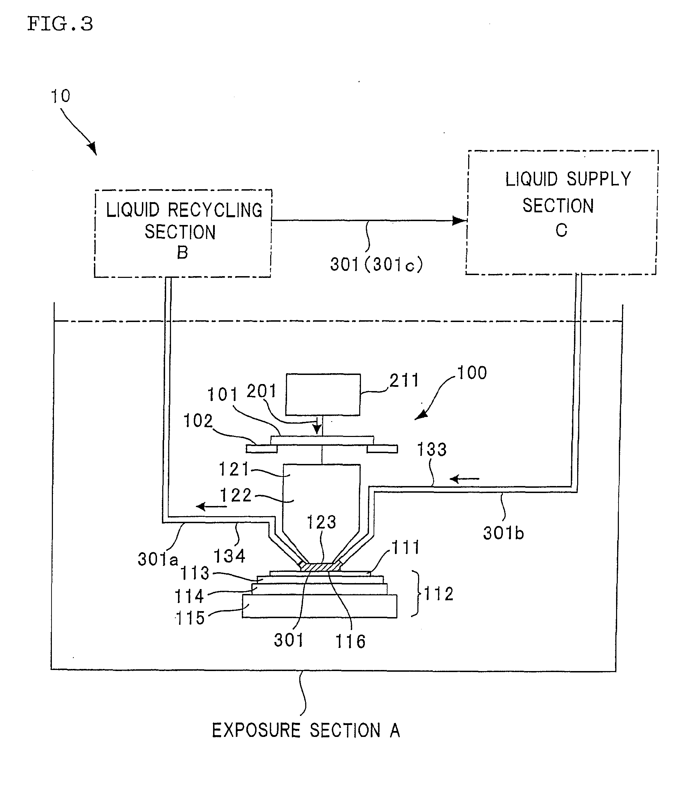

FIG 2 is a schematic flow diagram showing another embodiment of the immersion exposure system according to the present invention, and FIG 3 is a schematic configuration diagram showing one embodiment of an exposure device used for the immersion exposure system according to the present invention. The elements and the operation of an immersion exposure system 10 shown in FIGS. 2 and 3 and a method of recycling a liquid in the immersion exposure system according to the present invention are described below. The same elements as in FIG 1 are indicated by the same symbols. Description of these elements is omitted.

The immersion exposure system 10 includes an exposure section A, a liquid recycling section B, and a liquid supply section C. A (recycled) liquid 301 (301b) is supplied from the liquid supply section C to the exposure section A, and introduced into the space between an optical element of a projection optical means 121 and a substrate 111 in the exposure section A. The liquid 301 is come out of the space between the optical element of the projection optical means 121 and the substrate 111, and transferred to a circulating liquid storage tank 110 in the liquid recycling section B.

After removing impurities such as particles from the liquid 301 (301a) transferred to the circulating liquid storage tank 110 using a filter 117, impurities are further removed from the liquid using an impurity removal means 180 including a column chromatography purification means 150, a distillation means 160, and a filtration means 170. The liquid 301 (301c) from which impurities have been removed is transferred to and stored in a supply liquid storage tank 400 in the liquid supply section C. After removing gas from the liquid 301 (301b) using a degassing tool 401, necessary optical properties are monitored. The liquid 301 having specific optical properties is subjected to temperature control, filtered, supplied to an exposure section 110, and reused. The term "monitoring of necessary optical properties" refers to refractive index measurement at a wavelength of 193 nm conducted at a temperature of 23°C and absorbance (transmittance) measurement using a 1 cm measurement quartz cell, for example.

The configuration of the exposure section A is the same as that of the exposure section 110 shown in FIG 1. The liquid 301 (301b) is supplied from the liquid supply section C. The continuously introduced liquid 301 is come out of a space 116 between an end 123 of the projection optical means 121 and the substrate 111 at a symmetrical position against the substrate 111, and introduced into the circulating liquid storage tank 110 in the liquid recycling section B through a transfer pipe 134. Although this embodiment illustrates an example of the immersion exposure tool having one stage, the above description also applies to an immersion exposure tool having two stages.

The liquid recycling section B is described below. The liquid recycling section B includes the impurity removal means 180 including the column chromatography purification means 150, the distillation means 160, and the filtration means 170. The liquid 301 (301c) is recycled in the liquid recycling section B. In the column chromatography purification means 150, impurities are removed from the liquid 301 (301c) of which the purity is decreased by exposure and which contains impurities such as reaction byproducts and components of the resist film by passing through a column packed with an absorbent for adsorption chromatography. The distillation means 160 is used depending on the types of impurities in the liquid. For example, the organic layer is separated using a precision distillation tool at a temperature of 20°C under a vacuum of 1 mmHg, and impurities are removed using the filtration means 170 including a filter.

The liquid supply section C is described below. The liquid supply section C includes a degassing tool 401, a refractive index measuring means 402, an absorbance (transmittance) measuring means 403, a temperature controlling means 404, and a filtration means 405. The liquid 301 from which impurities have been removed in the liquid recycling section B is stored in the supply liquid storage tank 400. After removing gas from the liquid 301 using a degassing tool 401, necessary optical properties are monitored using the refractive index measuring means 402 and the absorbance (transmittance) measuring means 403. The liquid 301 having specific optical properties is controlled to desired temperature range using the temperature controlling means 404, filtered using the filtration means 405, supplied to the exposure section A, and reused.

At least two tanks are necessary as the supply liquid storage tank 400 in the liquid supply section C. One is a tank which stores a new liquid purified in a remote location, and the other is a tank which stores a circulating liquid. For example, when it is evaluated that impurities are contained in the liquid 301 and the liquid 301 is insufficiently recycled for exposure based on the refractive index and the transmittance obtained by online transmittance measurement using the absorbance (transmittance) measuring means 403 (out-of-specification), the line is switched to the tank containing a new liquid, and the tank used is transferred to the off-site recycling section in a remote location. In this case, since the out-of-specification liquid remains in the line, it is necessary to clean the pipe with a new liquid. Therefore, a tank (not shown) for recovering the liquid after cleaning is also necessary. The tank for recovering the liquid after washing is usually provided at a location separated from the liquid supply section C.

The liquid supply section C includes a pressure pump for supplying the recycled liquid 301 from the tank (container) to the exposure section A (immersion exposure tool A), a degassing means 401 for removing gas from the liquid 301, a temperature controlling means 404 for controlling the temperature of the liquid 301, and a filtration means 405. As the degassing means 401, a vacuum membrane degassing tool without using an inert gas is used, for example. The temperature controlling means 404 may be formed using a container provided with an electric heater (heater) and a refrigerant circulation pipe (cooler), for example. Gases dissolved in the recycled liquid 301 are completely removed using the degassing means 401, and the temperature of the recycled liquid 301 is controlled to a specific temperature using the temperature controlling means 404. After removing impurities from the liquid 301 using the filtration means 405, the liquid 301 is again supplied as the liquid 301 (301b) to the exposure section A through a supply pipe 133 due to the pressure of the pressure pump, and the liquid 301 (301b) is introduced into the space 116 between the end 123 of the projection optical means 121 and the substrate 111 in the exposure section A and reused. The temperature of the liquid 301 is usually controlled to the temperature of a clean room in which the exposure tool is installed (e.g. 23±0°C). Since the refractive index of the liquid 301 has a temperature dependence, it is desirable that the temperature of the supply pipe 133 and the like be stable so that the temperature of the liquid 301 supplied to the space 116 is 23±0.01°C. When the liquid from which impurities have been removed using the filtration means 405 does not have desired optical properties according to the present invention, a part of the liquid is recovered in the recovery tank 500.

The liquid recycling section B may include a monitoring means which can measure the refractive index and/or the transmittance of the liquid 301 in the tank.

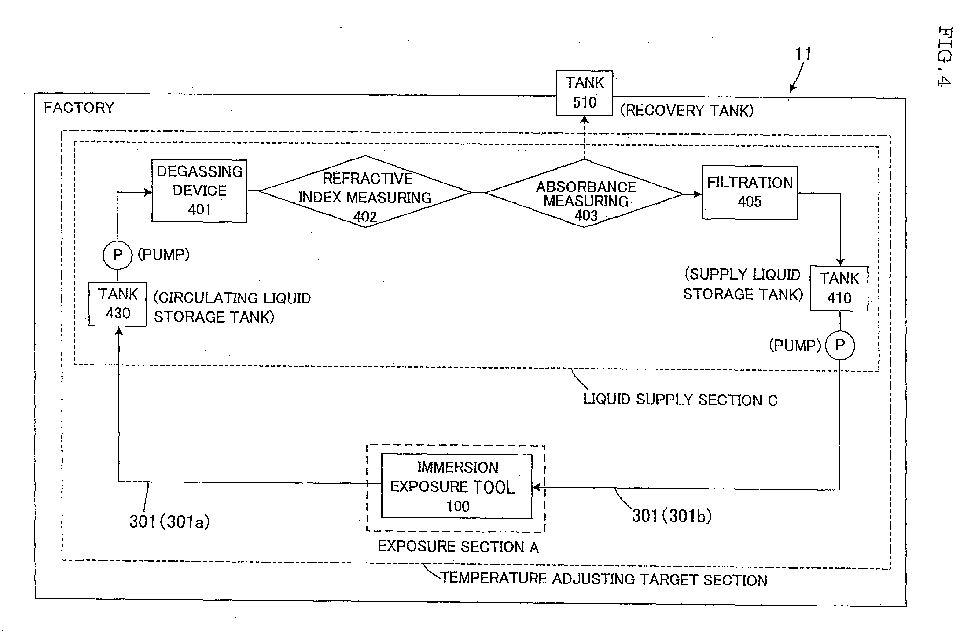

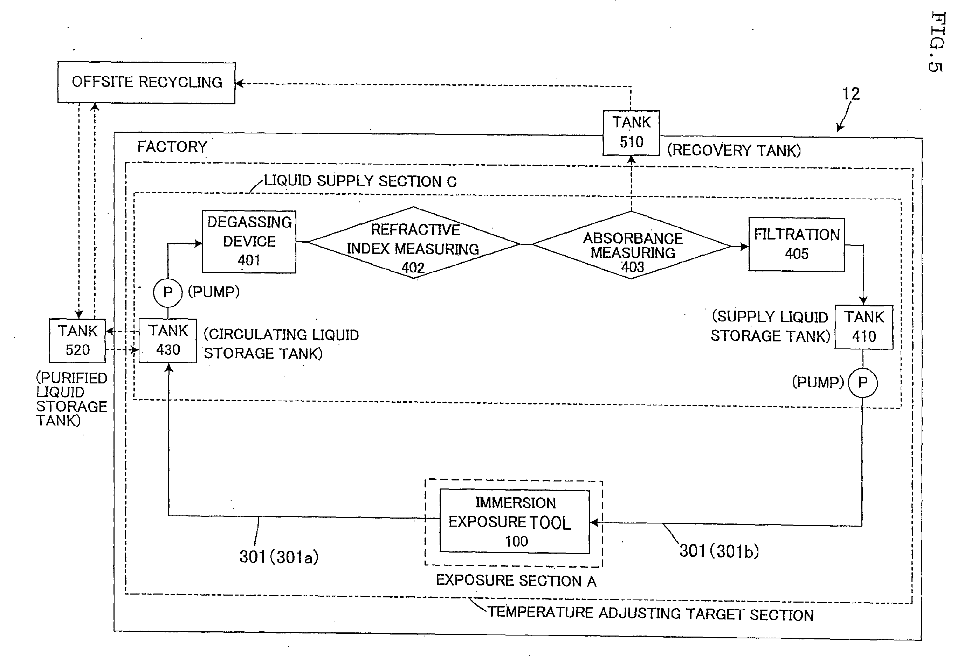

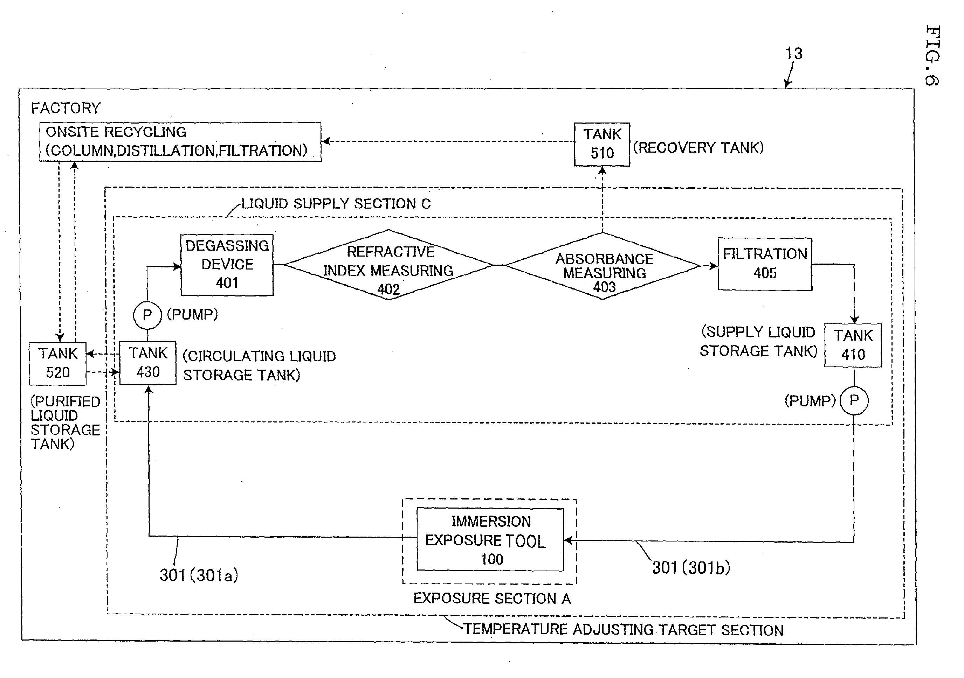

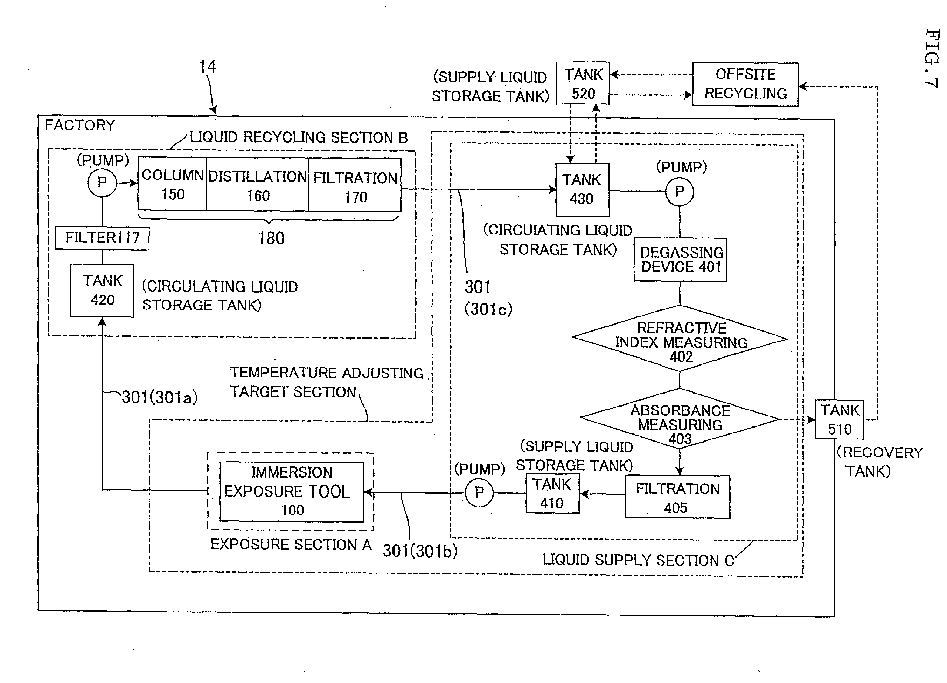

FIGS. 4 to 7 are schematic flow diagrams showing four examples of the immersion exposure system for carrying out a method of supplying an immersion exposure liquid according to the present invention. An immersion exposure system 11 shown in FIG 4, an immersion exposure system 12 shown in FIG 5, an immersion exposure system 13 shown in FIG 6, an immersion exposure system 14 shown in FIG 7, the process flow, the function and the effect of each element, and the method of supplying a liquid according to the present invention are described below. The same elements as in FIG 1 are indicated by the same symbols. Description of these elements is omitted.

The configuration of the exposure section A shown in FIG 4 is the same as that of the exposure section 110 shown in FIG 1. The immersion exposure system 11 includes at least a liquid supply section C and an exposure section A as the elements. The exposure section A includes an immersion exposure tool 100 as the main element. In one embodiment of supplying and discharging a liquid for immersion exposure, a liquid is continuously supplied from the liquid supply section C to the exposure section A. A liquid 301 is introduced into the space between an optical element of a projection optical means 121 and a substrate 111, and (continuously) come out of the space between the optical element of the projection optical means 121 and the substrate 111 at a symmetrical position against the substrate in the exposure section A. In another embodiment of supplying and discharging a liquid, the liquid 301 is supplied to a local region between the optical element of the projection optical means 121 and the substrate 111, and discharged from the local region. As examples of the above one embodiment, technologies disclosed in WO99/49504 and JP-A-2004-207711 can be given. As an example of the other embodiment, technology disclosed in JP-A-2004-343114 can be given.

The immersion exposure system 11 includes the exposure section A and the liquid supply section C. The liquid 301 (301b) having optical properties within specific ranges is supplied from the liquid supply section C to the exposure section A, and introduced into the space between the optical element of the projection optical means 121 and the substrate 111 in the exposure section A. The liquid 301 is come out of the space between the optical element of the projection optical means 121 and the substrate 111, and transferred to a circulating liquid storage tank 430.

After removing gas from the liquid 301 (301a) transferred to the circulating liquid storage tank 430 using a degassing tool 401, the optical properties are monitored. The liquid 301 having specific optical properties is filtered using a filtration tool 405, again supplied to the exposure section A, and reused. As the optical properties monitored, the refractive index at a wavelength of 193 nm and the absorbance (transmittance) using a 1 cm measurement quartz cell are measured. Since the refractive index varies to a large extent depending on the temperature, the temperature in the liquid supply section C and the exposure section A is strictly controlled to 23°C using a temperature controlling means, for example.

In the method of supplying a liquid according to the present invention, the means for filling the space between the surface of the substrate and the end of the projection optical means with the liquid is not limited insofar as the liquid must be supplied. The method also applies to the case of supplying a liquid to an exposure tool which performs an exposure process in a state in which the liquid remains stationary in the space between the surface of the substrate and the end of the projection optical means.

The liquid supply section C of the immersion exposure system 11 includes a degassing tool 401, a refractive index measuring means 402, an absorbance (transmittance) measuring means 403, and a filtration means 405. After removing gas from the liquid 301 transferred to the circulating liquid storage tank 430 using a degassing tool 401, the optical properties are monitored using the refractive index measuring means 402 and the absorbance (transmittance) measuring means 403. The liquid 301 having specific optical properties is filtered using the filtration means 405, supplied to the exposure section A through the supply liquid storage tank 410, and reused.

When it is evaluated that the optical properties the liquid 301 are outside specific ranges and the liquid 301 cannot be used for exposure based on the refractive index and the transmittance obtained by online transmittance measurement using the absorbance (transmittance) measuring means 403 (i.e. out-of-specification), the line is switched to a tank (not shown) containing a new liquid, and the out-of-specification liquid 301 is removed and introduced into a recovery tank 510. In this case, since the out-of-specification liquid remains in the line, it is necessary to clean the pipe with a new liquid. Therefore, a tank (not shown) for recovering the liquid after cleaning is also necessary. The tank for recovering the liquid after washing is usually provided at a location separated from the liquid supply section C.

As the degassing means 401, a vacuum membrane degassing tool without using an inert gas is used, for example. Gases dissolved in the recycled liquid 301 (301a) are completely removed using the degassing means 401. After removing impurities from the liquid 301 using the filtration means 405, the liquid 301 is again supplied as the liquid 301 (301b) to the exposure section A due to the pressure of a pressure pump provided in the supply liquid storage tank 410.

The immersion exposure system 13 shown in FIG 6 is described below. The immersion exposure system 13 is a system in which an on-site liquid recycling process is added to the immersion exposure system 11 shown in FIG 4. In the immersion exposure system 13, a liquid of which the optical properties are outside specific ranges and which is removed from the system and introduced into the recovery tank 510 is subjected to impurity removal using means such as chromatography, distillation, and filtration on-site (the same area as the exposure device (e.g. in the factory)). The liquid is purified so that the optical properties fall within specific ranges, returned to the liquid supply section C (circulating liquid storage tank 430) through a purified liquid storage tank 520, and reused. Since the optical properties are monitored in the liquid supply section C, even if insufficient purification occurs during the on-site recycling process or contamination occurs during transfer, the contaminated liquid is not transferred to the exposure section A.

The immersion exposure system 12 shown in FIG 5 is described below. The immersion exposure system 12 is a system in which an off-site liquid recycling process is added to the immersion exposure system 11 shown in FIG 4. In the immersion exposure system 12, a liquid of which the optical properties are outside specific ranges and which is removed from the system and introduced into the recovery tank 510 is subjected to impurity removal using means such as acid washing, alkali washing, water washing, and distillation off-site (remote location). The liquid is purified so that the optical properties fall within specific ranges, returned to the liquid supply section C (circulating liquid storage tank 430) through a purified liquid storage tank 520, and reused. Since the optical properties are monitored in the liquid supply section C, even if insufficient purification occurs during the off-site recycling process or contamination occurs during transfer, the contaminated liquid is not transferred to the exposure section A.

The immersion exposure system 14 shown in FIG 7 is described below. The immersion exposure system 14 is a system in which an on-site (factory) liquid recycling process is added to the immersion exposure system 12 to which the off-site recycling process (see FIG 5) is added. The on-site recycling process is performed in the liquid recycling section B shown in FIG 7.

Specifically, the immersion exposure system 14 includes the liquid recycling section B in addition to the exposure section A and the liquid supply section C. In the immersion exposure system 14, the (recycled) liquid 301 (301b) is supplied from the liquid supply section C to the exposure section A, passed through the exposure section A, and transferred to the circulating liquid storage tank 420 in the liquid recycling section B.

After removing impurities such as particles from the liquid 301 (301a) transferred to the circulating liquid storage tank 420 using the filter 117, impurities are further removed from the liquid using the impurity removal means 180. The liquid 301 (301c) from which impurities have been removed is transferred to the liquid supply section C (circulating liquid storage tank 430). After removing gas from the liquid 301 (301a) using the degassing tool 401, the optical properties are monitored in the same manner as the liquid 301 (301a) in the immersion exposure systems 11 and 12. The liquid 301 having specific optical properties is filtered and supplied to the exposure section A.

The liquid recycling section B of the immersion exposure system 14 includes an impurity removal means 180 including a column chromatography purification means 150, a distillation means 160, and a filtration means 170. The liquid 301 (301a) is recycled in the liquid recycling section B. In the column chromatography purification means 150, impurities are removed from the liquid 301 (301a), which contains impurities such as components of the resist film dissolved in the liquid upon contact with the resist film due to exposure, by passing through a column packed with an absorbent for adsorption chromatography. The distillation means 160 is used depending on the types of impurities in the liquid. For example, the organic layer is separated using a precision distillation tool at a temperature of 20°C under a vacuum of 1 mmHg, and impurities are removed using the filtration means 170 including a filter.

## INDUSTRIAL APPLICABILITY

The immersion exposure system according to the present invention may be used as an exposure means in various applications. In particular, the immersion exposure system according to the present invention is suitably used as an exposure means for transferring the pattern of a master onto a photosensitive material on a substrate when manufacturing electronic devices such as semiconductor devices, imaging devices (e.g. CCD and the like), liquid crystal display devices, and thin-film magnetic heads. The immersion exposure liquid disclosed in the present specification may be used as an inspection means using an optical system. The method of recycling an immersion exposure liquid according to the present invention may be used as a method of recycling a liquid used for an immersion exposure means which performs an exposure process through a liquid provided between an optical element of a projection optical means and a substrate. In particular, the method is suitably used when the liquid is an alicyclic hydrocarbon compound or the like. The method of supplying an immersion exposure liquid according to the present invention may be used as a means for supplying a liquid to an immersion exposure tool for various applications. In particular, the method is suitably used as a liquid supply means for an immersion exposure tool which transfers the pattern of a master onto a photosensitive material on a substrate when manufacturing electronic devices.

**Claims**

1. An immersion exposure system which performs an exposure process through a liquid provided between an optical element of projection optical means and a substrate, the immersion exposure system comprising:

   a liquid supply section which supplies the liquid;
   an exposure section which performs an exposure process in a state in which a space between the optical element of the projection optical means and the substrate is filled with the liquid supplied from the liquid supply section; and
   a liquid recycling section which recycles the liquid passed through the exposure section;
   the liquid recycled in the liquid recycling section being returned to the liquid supply section and reused.

2. The immersion exposure system according to claim 1, further comprising a liquid recovery section which recovers the liquid passed through the exposure section.

3. The immersion exposure system according to claim 2, wherein the liquid recycling section is provided independently of the liquid supply section, the exposure section, and the liquid recovery section.

4. The immersion exposure system according to claim 1, wherein the liquid recycling section is integrally provided with the liquid supply section and the exposure section.

5. The immersion exposure system according to any one of claims 1 to 4, wherein the liquid is a saturated hydrocarbon compound or a saturated hydrocarbon compound including a silicon atom in its structure.

6. The immersion exposure system according to any one of claims 1 to 4, wherein the liquid is an alicyclic hydrocarbon compound or a cyclic hydrocarbon compound including a silicon atom in its ring structure.

7. The immersion exposure system according to claim 6, wherein the alicyclic hydrocarbon compound or the cyclic hydrocarbon compound including a silicon atom in its ring structure has a transmittance of ArF laser light with a wavelength of 193 nm of 90% or more at an optical path length of 1 mm.

8. The immersion exposure system according to claim 6 or 7, wherein the alicyclic hydrocarbon compound or the cyclic hydrocarbon compound including a silicon atom in its ring structure has a transmittance of KrF laser light with a wavelength of 248 nm of 90% or more at an optical path length of 1 mm.

9. The immersion exposure system according to any one of claims 1 to 8, wherein the liquid supply section or the liquid recycling section includes monitoring means for monitoring optical properties of the liquid transferred.

10. The immersion exposure system according to any one of claims 1 to 9, wherein the liquid recycling section includes impurity removal means for removing impurities from the liquid recovered or transferred, and oxygen concentration control means for controlling oxygen concentration of the liquid recovered or transferred.

11. The immersion exposure system according to claim 10, wherein the impurity removal means includes one or two or more of acid washing means for removing basic impurities from the liquid using an acid solution, alkali washing means for removing acidic impurities from the liquid using an alkaline solution, water washing means for removing impurities from the liquid using pure water, and distillation means for separating impurities from the liquid utilizing a difference in boiling point.

12. The immersion exposure system according to claim 10, wherein the impurity removal means includes column chromatography purification means for removing impurities from the liquid by passing through a column packed with an absorbent for adsorption chromatography.

13. The immersion exposure system according to claim 10, wherein the impurity removal means includes at least one of distillation means for separating impurities from the liquid utilizing a difference in boiling point and filtration means for separating insoluble components from the liquid.

14. The immersion exposure system according to any one of claims 9 to 13, wherein the monitoring means for monitoring optical properties of the liquid includes absorbance measuring means for monitoring absorbance of the transferred liquid online.

15. The immersion exposure system according to any one of claims 1 to 13, wherein the liquid supply section includes degassing means for maintaining dissolved gas in the liquid at a desired concentration, and temperature adjusting means for maintaining the liquid at a desired temperature.

16. The immersion exposure system according to any one of claims 2, 3, and 5 to 15, wherein at least a container and a line used to return the liquid from the liquid recycling section to the liquid supply section is formed of a material without any leaching.

**17.** The immersion exposure system according to any one of claims 2, 3, and 5 to 16, wherein at least a container and a line used to return the liquid from the liquid recycling section to the liquid supply section is sealed with an inert gas.

**18.** The immersion exposure system according to any one of claims 2, 3, and 5 to 17, wherein the liquid recycling section is provided in a location away from a location in which at least the exposure section is provided.

**19.** A method of recycling an immersion exposure liquid used for an immersion exposure system or an immersion exposure method which performs an exposure process through a liquid provided between an optical element of projection optical means and a substrate, the method comprising a step A of recovering the liquid, a step B of recycling the recovered liquid, and a step C of introducing the recycled liquid into a space between the optical element of the projection optical means and the substrate and reusing the liquid.

**20.** The method according to claim 19, wherein the step B includes a step X of removing impurities from the recovered liquid and controlling oxygen concentration of the liquid, and a step Y of maintaining dissolved gas in the liquid at a desired concentration and maintaining the liquid at a desired temperature.

**21.** A method of supplying an immersion exposure liquid to an immersion exposure tool which performs an exposure process through a liquid provided between an optical element of projection optical means and a substrate, the method of supplying an immersion exposure liquid comprising monitoring optical properties of the liquid supplied to the immersion exposure tool, and supplying the liquid having optical properties within specific ranges.

**22.** The method according to claim 21, wherein the liquid having optical properties within specific ranges is always supplied to the immersion exposure tool by excluding the liquid of which the monitored optical properties are outside specific ranges.

**23.** The method according to claim 21 or 22, wherein the monitored optical properties of the liquid include a transmittance at 193 nm and/or a refractive index at 23°C.

**24.** The method according to any one of claims 21 to 23, wherein optical properties of the liquid are measured online when monitoring the optical properties of the liquid.

**25.** The method according to any one of claims 21 to 24, wherein the liquid is maintained in a specific temperature range in a liquid supply section which supplies the liquid and the immersion exposure tool to which the liquid is supplied.

**26.** The method according to claim 25, wherein the temperature of the liquid is adjusted to a value within ±0.1°C of a set temperature.

**27.** The method according to any one of claims 21 to 26, wherein the liquid of which the optical properties are monitored is a liquid which has been used in the immersion exposure tool at least once.

**28.** The method according to any one of claims 21 to 27, wherein the liquid used in and passed through the immersion exposure tool is recycled so that the liquid has optical properties within specific ranges, and the recycled liquid is again supplied to the immersion exposure tool.

**29.** The method according to claim 28, wherein the recycling includes a process of removing at least one of impurities, gases, and particles from the liquid transferred from the immersion exposure tool.

**30.** The method according to claim 29, wherein the process of removing impurities includes at least one of a column chromatography purification process which removes impurities from the transferred liquid by passing through a column packed with an absorbent for adsorption chromatography packing, a distillation process which separates impurities from the transferred liquid utilizing a difference in boiling point, a filtration process which separates insoluble components from the transferred liquid, and a degassing process which removes gas from the transferred liquid.

**31.** The method according to any one of claims 21 to 30, wherein the liquid is an alicyclic hydrocarbon compound or a cyclic hydrocarbon compound including a silicon atom in its ring structure.

**32.** The immersion exposure system according to claim 31, wherein the alicyclic hydrocarbon compound or the cyclic hydrocarbon compound including a silicon atom in its ring structure has a transmittance of ArF laser light with a wavelength of 193 nm of 90% or more at an optical path length of 1 mm.

**Amended claims under Art. 19.1 PCT**

**1.** (Amended) An immersion exposure system which performs an exposure process through a liquid provided between an optical element of projection optical means and a substrate, the liquid being a saturated hydrocarbon compound or a saturated hydrocarbon compound including a silicon atom in its structure, the immersion exposure system comprising:

a liquid supply section which supplies the liquid;
an exposure section which performs an exposure process in a state in which a space between the optical element of the projection optical means and the substrate is filled with the liquid supplied from the liquid supply section; and
a liquid recycling section which recycles the liquid passed through the exposure section;
the liquid recycled in the liquid recycling section being returned to the liquid supply section and reused.

**2.** The immersion exposure system according to claim 1, further comprising a liquid recovery section which recovers the liquid passed through the exposure section.

**3.** The immersion exposure system according to claim 2, wherein the liquid recycling section is provided independently of the liquid supply section, the exposure section, and the liquid recovery section.

**4.** The immersion exposure system according to claim 1, wherein the liquid recycling section is integrally provided with the liquid supply section and the exposure section.

**5.** (Canceled)

**6.** The immersion exposure system according to any one of claims 1 to 4, wherein the liquid is an alicyclic hydrocarbon compound or a cyclic hydrocarbon compound including a silicon atom in its ring structure.

**7.** The immersion exposure system according to claim 6, wherein the alicyclic hydrocarbon compound or the cyclic hydrocarbon compound including a silicon atom in its ring structure has a transmittance of ArF laser light with a wavelength of 193 nm of 90% or more at an optical path length of 1 mm.

**8.** The immersion exposure system according to claim 6 or 7, wherein the alicyclic hydrocarbon compound or the cyclic hydrocarbon compound including a silicon atom in its ring structure has a transmittance of KrF laser light with a wavelength of 248 nm of 90% or more at an optical path length of 1 mm.

**9.** (Amended) The immersion exposure system according to any one of claims 1 to 4 and 6 to 8, wherein the liquid supply section or the liquid recycling section includes monitoring means for monitoring optical properties of the liquid transferred.

**10.** (Amended) The immersion exposure system according to any one of claims 1 to 4 and 6 to 9, wherein the liquid recycling section includes impurity removal means for removing impurities from the liquid recovered or transferred, and oxygen concentration control means for controlling oxygen concentration of the liquid recovered or transferred.

**11.** The immersion exposure system according to claim 10, wherein the impurity removal means includes one or two or more of acid washing means for removing basic impurities from the liquid using an acid solution, alkali washing means for removing acidic impurities from the liquid using an alkaline solution, water washing means for removing impurities from the liquid using pure water, and distillation means for separating impurities from the liquid utilizing a difference in boiling point.

**12.** The immersion exposure system according to claim 10, wherein the impurity removal means includes column chromatography purification means for removing impurities from the liquid through a column charged with an absorbent for adsorption chromatography.

**13.** The immersion exposure system according to claim 10, wherein the impurity removal means includes at least one of distillation means for separating impurities from the liquid utilizing a difference in boiling point and filtration means for separating insoluble components from the liquid.

**14.** The immersion exposure system according to any one of claims 9 to 13, wherein the monitoring means for monitoring optical properties of the liquid includes absorbance measuring means for monitoring absorbance of the transferred liquid online.

**15.** (Amended) The immersion exposure system according to any one of claims 1 to 4 and 6 to 13, wherein the liquid supply section includes degassing means for maintaining dissolved gas in the liquid at a desired concentration, and temperature adjusting means for maintaining the liquid at a desired temperature.

**16.** (Amended) The immersion exposure system according to any one of claims 1 to 3 and 6 to 15, wherein at least a container and a line used to return the liquid from the liquid recycling section to the liquid supply section is formed of a material which rarely allows elution.

**17.** (Amended) The immersion exposure system according to any one of claims 1 to 3 and 6 to 16, wherein at least a container and a line used to return the liquid from the liquid recycling section to the liquid supply section is sealed with an inert gas.

**18.** (Amended) The immersion exposure system according to any one of claims 1 to 3 and 6 to 17, wherein the liquid recycling section is provided in a location away from a location in which at least the exposure section is provided.

**19.** (Amended) A method of recycling an immersion exposure, liquid used for an immersion exposure system or an immersion exposure method which performs an exposure process through a liquid provided between an optical element of projection optical means and a substrate, the liquid being a saturated hydrocarbon compound or a saturated hydrocarbon compound including a silicon atom in its structure, the method comprising a step A of recovering the liquid, a step B of recycling the recovered liquid, and a step C of introducing the recycled liquid into a space between the optical element of the projection optical means and the substrate and reusing the liquid.

**20.** The method according to claim 19, wherein the step B includes a step X of removing impurities from the recovered liquid and controlling oxygen concentration of the liquid, and a step Y of maintaining dissolved gas in the liquid at a desired concentration and maintaining the liquid at a desired temperature.

**21.** (Amended) A method of supplying an immersion exposure liquid to an immersion exposure tool which performs an exposure process through a liquid provided between an optical element of projection optical means and a substrate, the liquid being a saturated hydrocarbon compound or a saturated hydrocarbon compound including a silicon atom in its structure, the method comprising monitoring optical properties of the liquid supplied to the immersion exposure tool, and supplying the liquid having optical properties within specific ranges.

**22.** The method according to claim 21, wherein the liquid having optical properties within specific ranges is always supplied to the immersion exposure tool by excluding the liquid of which the monitored optical properties are outside specific ranges.

**23.** The method according to claim 21 or 22, wherein the monitored optical properties of the liquid include a transmittance at 193 nm and/or a refractive index at 23°C.

**24.** The method according to any one of claims 21 to 23, wherein optical properties of the liquid are measured online when monitoring the optical properties of the liquid.

**25.** The method according to any one of claims 21 to 24, wherein the liquid is maintained in a specific temperature range in a liquid supply section which supplies the liquid and the immersion exposure tool to which the liquid is supplied.

**26.** The method according to claim 25, wherein the temperature of the liquid is adjusted to a value within $\pm 0.1$°C of a set temperature.

**27.** The method according to any one of claims 21 to 26, wherein the liquid of which the optical properties are monitored is a liquid which has been used in the immersion exposure tool at least once.

**28.** The method according to any one of claims 21 to 27, wherein the liquid used in and passed through the immersion exposure tool is recycled so that the liquid has optical properties within specific ranges, and the recycled liquid is again supplied to the immersion exposure tool.

**29.** The method according to claim 28, wherein the recycling includes a process of removing at least one of impurities, gases, and particles from the liquid transferred from the immersion exposure tool.

**30.** The method according to claim 29, wherein the process of removing impurities includes at least one of a column chromatography purification process which removes impurities by causing the transferred liquid to pass through a column charged with an absorbent for adsorption chromatography, a distillation process which separates impurities from the transferred liquid utilizing a difference in boiling point, a filtration process which separates insoluble components from the transferred liquid, and a degassing process which removes gas from the transferred liquid.

**31.** The method according to any one of claims 21 to 30, wherein the liquid is an alicyclic hydrocarbon compound or a cyclic hydrocarbon compound including a silicon atom in its ring structure.

**32.** The immersion exposure system according to claim 31, wherein the alicyclic hydrocarbon compound or the cyclic hydrocarbon compound including a silicon atom in its ring structure has a transmittance of ArF laser light with a wavelength of 193 nm of 90% or more at an optical path length of 1 mm.

FIG. 1

FIG.2

OFFSITE RECYCLING
10
LIQUID RECYCLING SECTION B
P
COLUMN 150
DISTILLATION 160
FILTRATION 170
180
FILTER
117
TANK 110
(CIRCULATING LIQUID STORAGE TANK)
301(301a)
(SUPPLY LIQUID STORAGE TANK)
TANK 400
301 (301c)
(PUMP)
P
401
DEGASSING DEVICE
402
REFRACTIVE INDEX MEASURING
403
ABSORBANCE MEASURING
404
TEMPERATURE ADJUSTING
405
FILTRATION
LIQUID SUPPLY SECTION C
500
RECOVERY TANK
301 (301b)
IMMERSION EXPOSURE TOOL 100
EXPOSURE SECTION A

FIG.3

10
LIQUID RECYCLING SECTION B
LIQUID SUPPLY SECTION C
301(301c)
211
100
101
201
102
133
121
122
123
301b
301a
134
111
113
114
115
112
301
116
EXPOSURE SECTION A

FIG.4

11
FACTORY
TANK 510
(RECOVERY TANK)
DEGASSING DEVICE 401
REFRACTIVE INDEX MEASURING 402
ABSORBANCE MEASURING 403
FILTRATION 405
TANK 410
P
(PUMP)
(SUPPLY LIQUID STORAGE TANK)
TANK 430
P
(PUMP)
(CIRCULATING LIQUID STORAGE TANK)
LIQUID SUPPLY SECTION C
IMMERSION EXPOSURE TOOL 100
EXPOSURE SECTION A
301 (301b)
301 (301a)
TEMPERATURE ADJUSTING TARGET SECTION

FIG.5

OFFSITE RECYCLING
12
TANK 510
(RECOVERY TANK)
FACTORY
LIQUID SUPPLY SECTION C
DEGASSING DEVICE 401
REFRACTIVE INDEX MEASURING 402
ABSORBANCE MEASURING 403
FILTRATION 405
P
(PUMP)
TANK 520
(PURIFIED LIQUID STORAGE TANK)
TANK 430
(CIRCULATING LIQUID STORAGE TANK)
(SUPPLY LIQUID STORAGE TANK)
TANK 410
(PUMP)
P
IMMERSION EXPOSURE TOOL 100
301 (301a)
301 (301b)
EXPOSURE SECTION A
TEMPERATURE ADJUSTING TARGET SECTION

FIG.6

13
FACTORY
ONSITE RECYCLING
(COLUMN,DISTILLATION,FILTRATION)
TANK
510
(RECOVERY TANK)
LIQUID SUPPLY SECTION C
DEGASSING DEVICE
401
REFRACTIVE INDEX MEASURING
402
ABSORBANCE MEASURING
403
FILTRATION
405
P
(PUMP)
(SUPPLY LIQUID STORAGE TANK)
TANK
410
TANK
520
TANK
430
(CIRCULATING LIQUID STORAGE TANK)
(PURIFIED LIQUID STORAGE TANK)
(PUMP)
P
IMMERSION EXPOSURE TOOL
100
301 (301a)
301 (301b)
EXPOSURE SECTION A
TEMPERATURE ADJUSTING TARGET SECTION

FIG.7

OFFSITE RECYCLING
TANK 510
(RECOVERY TANK)
TANK 520
(SUPPLY LIQUID STORAGE TANK)
(PUMP)
P
TANK 430
(CIRCUIATING LIQUID STORAGE TANK)
DEGASSING DEVICE 401
REFRACTIVE INDEX MEASURING 402
ABSORBANCE MEASURING 403
FILTRATION 405
TANK 410
(SUPPLY LIQUID STORAGE TANK)
LIQUID SUPPLY SECTION C
301 (301c)
301(301b)
TEMPERATURE ADJUSTING TARGET SECTION
IMMERSION EXPOSURE TOOL 100
EXPOSURE SECTION A
LIQUID RECYCLING SECTION B
COLUMN 150
DISTILLATION 160
FILTRATION 170
180
(CIRCULATING LIQUID STORAGE TANK)
TANK 420
FILTER117
301(301a)
14
FACTORY

## INTERNATIONAL SEARCH REPORT

International application No.
PCT/JP2006/300840

A. CLASSIFICATION OF SUBJECT MATTER
*H01L21/027*(2006.01), *G03F7/038*(2006.01), *G03F7/20*(2006.01)

According to International Patent Classification (IPC) or to both national classification and IPC

B. FIELDS SEARCHED

Minimum documentation searched (classification system followed by classification symbols)
H01L21/027, G03F7/038, G03F7/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
CA(STN)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2004/053955 A1 (Nikon Corp.),<br>24 June, 2004 (24.06.04),<br>Claims; description; page 50, lines 4 to 6<br>& US 2005/0259234 A1 & EP 1571697 A1 | 1-4,15-19<br>9,21-30 |
| X<br>Y | JP 2005-005713 A (ASML NETHERLANDS B.V.),<br>16 January, 2005 (16.01.05),<br>Claims; Par. Nos. [0076] to [0079]<br>& EP 1489461 A1 & US 2005/0225734 A1 | 1-4,15-19<br>9,21-30 |
| X<br>Y | WO 99/49504 A1 (Nikon Corp.),<br>30 September, 1999 (30.09.99),<br>Claims; description; page 20, lines 7 to 9<br>& AU 2747999 A | 1-4,15-19<br>9,21-30 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 April, 2006 (17.04.06) | 25 April, 2006 (25.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/300840

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-301825 A (Nikon Corp.), 28 October, 2004 (28.10.04), Claims & WO 2004/053957 A1 | 9,21-30 |
| A | JP 9-241214 A (CARL ZEISS), 16 September, 1997 (16.09.97), Claims & US 5817256 A | 5-8,31,32 |
| P,A | JP 2005-072230 A (Matsushita Electric Industrial Co., Ltd.), 17 March, 2005 (17.03.05), Claims (Family: none) | 5-8,31,32 |
| P,A | JP 2005-079584 A (ASML NETHERLANDS B.V.), 24 March, 2005 (24.03.05), Claims & US 2005/0078287 A1 & EP 1510872 A2 | 1-32 |
| P,A | JP 2006-004964 A (NEC Electronics Corp.), 05 January, 2006 (05.01.06), Claims & US 2005/0275817 A1 & EP 1632810 A2 | 1-32 |
| P,A | WO 2005/114711 A1 (JSR Corp.), 01 December, 2005 (01.12.05), Claims (Family: none) | 1-32 |

Form PCT/ISA/210 (continuation of second sheet) (April 2005)

**INTERNATIONAL SEARCH REPORT**

International application No.
PCT/JP2006/300840

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The "special technical feature" of the invention of claims 1-20 is recycle of a liquid for immersion exposure, while the "special technical feature" of the invention of claims 21-32 is a supply method of a liquid for immersion exposure which is not always limited to recycle methods of a liquid for immersion exposure. Since there is no technical relationship between these inventions involving one or more of the same or corresponding special technical features, these inventions are not considered so linked as to form a single general inventive concept.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 11176727 A
- WO 9949504 A
- JP 2004151711 A
- JP 2004252289 A
- JP 2004207711 A
- JP 2004343114 A

### Non-patent literature cited in the description

- *NIKKEI MICRODEVICE,* April 2004, 77